(19) Europäisches Patentamt
European Patent Office
Office européen des brevets

(11) **EP 4 552 991 A1**

(12) **EUROPEAN PATENT APPLICATION**
published in accordance with Art. 153(4) EPC

(43) Date of publication:
**14.05.2025 Bulletin 2025/20**

(21) Application number: **23835162.1**

(22) Date of filing: **19.05.2023**

(51) International Patent Classification (IPC):
**B65D 23/02** (2006.01)  **C23C 16/505** (2006.01)

(52) Cooperative Patent Classification (CPC):
**B65D 23/02; C23C 16/505**

(86) International application number:
**PCT/JP2023/018681**

(87) International publication number:
**WO 2024/009625 (11.01.2024 Gazette 2024/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **07.07.2022 JP 2022109496**

(71) Applicant: **Mitsubishi Heavy Industries Machinery
Systems, Ltd.
Kobe-shi, Hyogo 652-8585 (JP)**

(72) Inventors:
• **HIROYA, Kiyoshi**
  **Kobe-shi, Hyogo 652-8585 (JP)**
• **YAMADA, Masahiro**
  **Kobe-shi, Hyogo 652-8585 (JP)**
• **IMAMINE, Kazuya**
  **Kobe-shi, Hyogo 652-8585 (JP)**

(74) Representative: **Hoffmann Eitle
Patent- und Rechtsanwälte PartmbB
Arabellastraße 30
81925 München (DE)**

(54) **FILM FORMING AUXILIARY TOOL, FILM FORMING DEVICE, AND METHOD FOR
MANUFACTURING FILM CONTAINER**

(57)    The purpose of the present invention is to further improve the degree of freedom in the shape of a container that can secure a gas barrier property regardless of adjustment of the shape or the like of an external electrode, when forming a barrier film applied to the container by using a high-frequency electric field. An auxiliary tool used for a film forming device that forms a film on an inner surface of a container is configured to be insertable into an external electrode that accommodates the container. The auxiliary tool comprises a dielectric part stacked on a conductor part. When the auxiliary tool is inserted into the external electrode, the dielectric part faces the outer surface of the container, and when the auxiliary tool is inserted into the external electrode, the dielectric part and the conductor part are disposed in this order from the container between the container and the external electrode.

FIG. 1

**Description**

Technical Field

The present disclosure relates to an auxiliary tool used in film formation of a container, a device including the auxiliary tool, and a method for manufacturing a container having a coating film using the auxiliary tool.

Background Art

A thin film (barrier film) is formed on a container made of a resin to impart gas barrier properties. The barrier film has gas barrier properties that prevent permeation of a gas and corresponds to, for example, a diamond-like carbon (DLC) thin film. The DLC film can be formed, for example, by decomposing and ionizing a raw material gas with plasma generated in a decompressed space using a high-frequency electric field and causing ions accelerated by the electric field to collide with a surface of the container through, for example, a plasma-enhanced chemical vapor deposition (PECVD) method (PTL 1 and the like).

For example, in a case where a barrier film is formed on an inner surface of the container, a device used in formation of such a barrier film includes an external electrode that is a chamber which is divided and which can accommodate the container, an internal electrode that is an electrode inserted into the container and that serves as an introduction pipe for a raw material gas, an exhaust device that exhausts the chamber, and a high-frequency power supply.

In the related art, a device and a method for forming a barrier film have main problems in suppression of occurrence of abnormal discharge in a gap of a division surface of the external electrode and making a state (film thickness or the like) of the barrier film uniform, in addition to improvement of gas barrier properties. In particular, when a container having a neck portion that is narrow with respect to a body portion, such as a bottle-shaped container, is typically accommodated in a chamber consisting of an external electrode formed in a cylindrical shape, a state of the barrier film is likely to be non-uniform due to a bias in electric flux density or the like, and thus it is difficult to sufficiently obtain gas barrier properties.

As a basic measure for suppressing occurrence of abnormal discharge and uniformly forming a barrier film, a dielectric is disposed between the external electrode and the container as described in PTLs 1 to 4.

In PTLs 2 and 3, in order to improve gas barrier properties, a region of the external electrode facing the neck portion is formed to be thick, and a layer of the dielectric having a constant thickness is superimposed on an inner peripheral portion of the external electrode such that the neck portion of the container and the external electrode are brought close to each other. The dielectric in PTL 4 is disposed along the surface of the container to fill a space between the external electrode and the container.

A posture of the container during film formation may be upright or inverted. For example, when the container in an upright posture is inserted from the neck portion into an opening of the external electrode and the opening is closed as in PTLs 2 and 3, a bottom portion of the container is supported by a bottom portion of the external electrode. When the container in an inverted posture is inserted from the neck portion into the opening of the external electrode and the opening is closed as in PTL 4, a mouth portion of the container is supported by the bottom portion of the external electrode. When the entire container is accommodated in the chamber, the dielectric provided in the external electrode is disposed to face the body portion, the neck portion, and the bottom portion of the container.

Since a displacement current flows in the dielectric due to application of an alternating electric field, a gap is allowed between the neck portion and the dielectric as in PTLs 2 and 3. However, in order to sufficiently obtain gas barrier properties, it is necessary to dispose the external electrode and the dielectric along an outer surface of the container to some extent in the related art.

Thus, PTL 1 discloses a means for making it possible to improve gas barrier properties by making a voltage uniform without necessarily disposing the external electrode and the dielectric on the outer surface of the container.

In PTL 1, a "conversion distance" obtained by dividing a thickness of the dielectric or a gap between the external electrode and the container by a dielectric constant is defined. As a means for making an applied voltage uniform, a material for the dielectric, thicknesses of the dielectric and the gap, and a shape of the external electrode are combined such that a sum of conversion distances from the external electrode to the container is uniform in the entire container.

In this case, since it is not necessary to give the external electrode and the dielectric a shape similar to the shape of the container, a cylindrical external electrode and a cylindrical dielectric can be basically used in common for containers having different shapes. For this reason, when changing a mold, it is not always necessary to replace the external electrode and the dielectric. In addition, in a case where the cylindrical external electrode and the cylindrical dielectric are used, the container can be inserted from the bottom portion into the opening of the external electrode without interfering with the container or a grip tool with the dielectric or the external electrode in a state where the neck portion is gripped by the grip tool.

Citation List

Patent Literature

[PTL 1] Japanese Patent No. 5355860

[PTL 2] Japanese Unexamined Patent Application Publication No. 2019-065318

[PTL 3] Japanese Unexamined Patent Application Publication No. 2013-256708

[PTL 4] Japanese Unexamined Patent Application Publication No. 2009-046182

Summary of Invention

Technical Problem

According to the means of PTL 1, since a degree of freedom of the shape of the container, which is a film formation target, is improved, gas barrier properties can be sufficiently obtained by making a film thickness or the like of the barrier film uniform while allowing various shapes of containers such as a container having unevenness in the body portion.
However, in recent years, the shape of the container has become more and more diversified, and thus it is difficult to sufficiently obtain gas barrier properties depending on the shape of the container.
For example, a case where the container having the neck portion extending over 1/2 of the height of the container is accommodated inside the cylindrical external electrode, and the dielectric having a shape similar to the shape of the neck portion is disposed between the external electrode and the container to form a barrier film on the container will be examined. The dielectric formed to be thick is disposed between the external electrode and the neck portion, and a thick region of the dielectric extends over 1/2 of the height of the container, similar to the neck portion. In this case, even when gas barrier properties of a region of the body portion are good, a region of the neck portion having relatively poor gas barrier properties occupies up to half of the height of the container. Energy of a high-frequency electric field is attenuated by the thick region of the dielectric facing the neck portion.
Herein, gas barrier properties based on oxygen permeability correspond to a sum of gas barrier properties according to a surface area of each region when the container is divided into a plurality of regions. According to measurement of the oxygen permeability of the container after film formation by the present inventors, the gas barrier properties of the container exemplified above, that is, the container having an excessively large area proportion of a region having relatively poor gas barrier properties to the entire container are insufficient.
That is, depending on the shape of the container, even when the dielectric is given the shape similar to the shape of the container, a sufficient level of gas barrier properties cannot always be realized for the entire container. In order to realize this, when the external electrode is given the shape similar to the shape of the container, it is necessary to prepare the external electrode for each container having a different shape, and work of replacing the external electrode occurs when changing a mold.
In view of the above, an object of the present disclosure is to further improve a degree of freedom in a shape of a container which ensures gas barrier properties regardless of adjustment of a shape of an external electrode or the like, in formation of a barrier film applied to the container using a high-frequency electric field.

Solution to Problem

A film forming auxiliary tool according to the present disclosure is used in a film-forming device performing film formation on an inner surface of a container. Such an auxiliary tool is configured to be inserted into an external electrode that accommodates the container. In addition, such an auxiliary tool includes a conductor portion and a dielectric portion that is stacked on the conductor portion, when the auxiliary tool is inserted into the external electrode, the dielectric portion faces an outer surface of the container, and when the auxiliary tool is inserted into the external electrode, the dielectric portion and the conductor portion are disposed in this order from a container side between the container and the external electrode.
A film-forming device according to the present disclosure is a device performing film formation on an inner surface of a container and includes an external electrode that is configured to accommodate the container, an internal electrode that is disposed inside the container, and the auxiliary tool described above.
A method for manufacturing a film-coated container according to the present disclosure is a method for manufacturing a container having a coating film on an inner surface of the container and includes a step of disposing the auxiliary tool described above around the container, a step of accommodating the container and the auxiliary tool inside the external electrode, a step of exhausting a space where the container is disposed and introducing a gas containing a raw material for a film to be applied to the container, and a step of applying an electric field between the external electrode and an internal electrode disposed inside the container.

Advantageous Effects of Invention

The film forming auxiliary tool of the present disclosure is an auxiliary tool for film formation that is a separate body from the external electrode and that is configured to be inserted into the external electrode and includes the conductor portion and the dielectric portion. By using this film forming auxiliary tool, it is possible to suppress occurrence of abnormal discharge with the dielectric portion of the auxiliary tool and to dispose the conductor portion close to a region of the container where the gas barrier properties are poor without changing the shape of the external electrode or the dielectric portion attached in advance to the external electrode in accordance with the shape of the container, even when the container is a container with which the gas barrier properties are difficult to be ensured due to shape characteristics.

When the auxiliary tool is inserted into the external electrode, the dielectric portion of the auxiliary tool facing the outer surface of the container and the conductor portion of the auxiliary tool are both disposed between the container and the external electrode. The auxiliary tool can be disposed around the container outside the external electrode, and the auxiliary tool can be inserted into the external electrode together with the container.

When the barrier film is formed on the container using the auxiliary tool, a distance from the conductor portion to the container is short, so that gas barrier properties in the region of the container where the auxiliary tool is disposed are improved. As the conductor portion of the auxiliary tool is disposed between the container and the external electrode, the thickness of the dielectric between the container and the external electrode is reduced, and a dielectric loss is reduced, so that the gas barrier properties in the region are improved.

In this manner, the gas barrier properties of the entire container are improved, and thus the gas barrier properties can be ensured in containers having various shapes while suppressing occurrence of abnormal discharge.

Brief Description of Drawings

Fig. 1 is a view showing an overall configuration of a film-forming device according to an embodiment of the present disclosure.

Fig. 2A is a sectional view taken along line IIa-IIa of Fig. 1. Fig. 2B is a side view of a container which is a film formation target.

Fig. 3 is a cross-sectional view showing a modification example related to a shape of a cross section of the container and an auxiliary tool.

Figs. 4A to 4D are sectional views of a film forming auxiliary tool that can be used in film formation of the container shown in Fig. 1, respectively.

Fig. 5 is a flowchart showing a processing procedures for manufacturing the container to which a barrier film is applied.

Fig. 6 is a view showing a state where the container in an inverted posture is delivered from a grip tool of a transport device to a grip tool of the film-forming device.

Fig. 7 is a view showing a state where the auxiliary tool is disposed around the container.

Fig. 8A is a view showing a state where the container and the auxiliary tool are accommodated inside an external electrode and a dielectric portion. In this state, a film formation treatment in which the barrier film is applied to an inner surface of the container is performed.

Fig. 9 is a view for describing the film formation treatment on the container gripped in an upright posture.

Figs. 10A and 10B are views for describing a reason why gas barrier properties are improved by using the auxiliary tool. Fig. 10B is a view showing a state where a region of the external electrode is conceptually expanded by using the auxiliary tool.

Fig. 11A is a view showing an example in which an auxiliary tool consisting of only a conductor is disposed around a neck portion of the container, instead of the auxiliary tool according to the present disclosure. Fig. 11B is a view showing a state where a part of a region of the dielectric portion already provided in the external electrode shown in Fig. 11A is replaced with the auxiliary tool.

Fig. 12 is a view showing a typical beverage bottle in order to consider a relationship between gas barrier properties of each region of the container and gas barrier properties of the entire container.

Fig. 13 is a view for describing making a voltage applied to the inner surface of the container uniform by using the dielectric portion and a gap.

Fig. 14 is a view for describing gas barrier properties at a time of film formation using the auxiliary tool, which is a dielectric, and showing an application example of the auxiliary tool according to the present disclosure to a container having a different shape.

Fig. 15 is a vertical sectional view showing a modification example of a configuration of the auxiliary tool.

Fig. 16 is a sectional view taken along line XVI-XVI of Fig. 14.

Fig. 17 is a perspective view showing a modification example of the configuration of the auxiliary tool.

Fig. 18 is a view showing an application example of the auxiliary tool to a bottom portion of the container.

Fig. 19 is a vertical sectional view showing a modification example related to support of the container during film formation, support of the auxiliary tool, and division of the external electrode and the like.

Description of Embodiments

Hereinafter, an embodiment will be described with reference to the accompanying drawings.

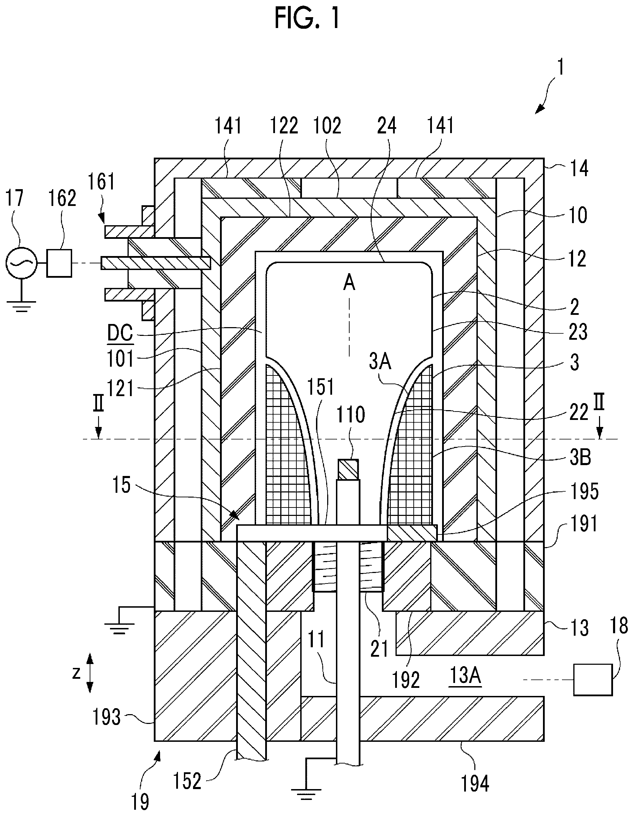

A film-forming device 1 shown in Fig. 1 forms a barrier film (not shown) on an inner surface of a container 2 made of a resin by generating plasma in a decompressed space using a high-frequency electric field. The barrier film corresponds to a dense film that can suppress permeation of a gas, such as a carbon film including diamond-like carbon (DLC) and a silica film.

The container 2 is formed in a bottle shape of a resin material such as polyethylene terephthalate (PET) and polypropylene (PP). The container 2 has a neck portion 22 having a longer dimension than a dimension of a cylindrical body portion 23 in a height direction along an axis A of the container 2, unlike a shape of a typical beverage bottle. The container 2 can be divided into respective regions including a mouth portion 21 on which a lid (not shown) is mounted after filling the container 2 with contents, the neck portion 22 continuous to the mouth portion 21, the body portion 23, and a bottom portion 24. A diameter of the neck portion 22 gradually increases from the mouth portion 21 toward the body portion 23.

The film-forming device 1 constitutes, for example, a part of a line for manufacturing a beverage product, a detergent, a pharmaceutical product, or the like, and the container 2 is mainly filled with liquid contents. The barrier film applied to the container 2 maintains the quality of the contents filling the container 2 by imparting gas barrier properties to the container 2 to suppress permeation of a gas and adsorption of the gas to the container 2. An aspect in which the gas permeates the container 2 includes, for example, a case where a gas such as oxygen outside the container 2 permeates the inside of the container 2 and a case where a gas such as carbon dioxide inside the container 2 permeates the outside of the container 2.

In the film-forming device 1, a degree of freedom in the shape of the container 2, which ensures the gas barrier properties, can be significantly improved by use of an auxiliary tool 3 that is used by being inserted into an external electrode 10 during film formation. For this reason, the film-forming device 1 can realize a required level of gas barrier properties not only for a bottle container having a typical shape but also for the container 2 having a special shape.

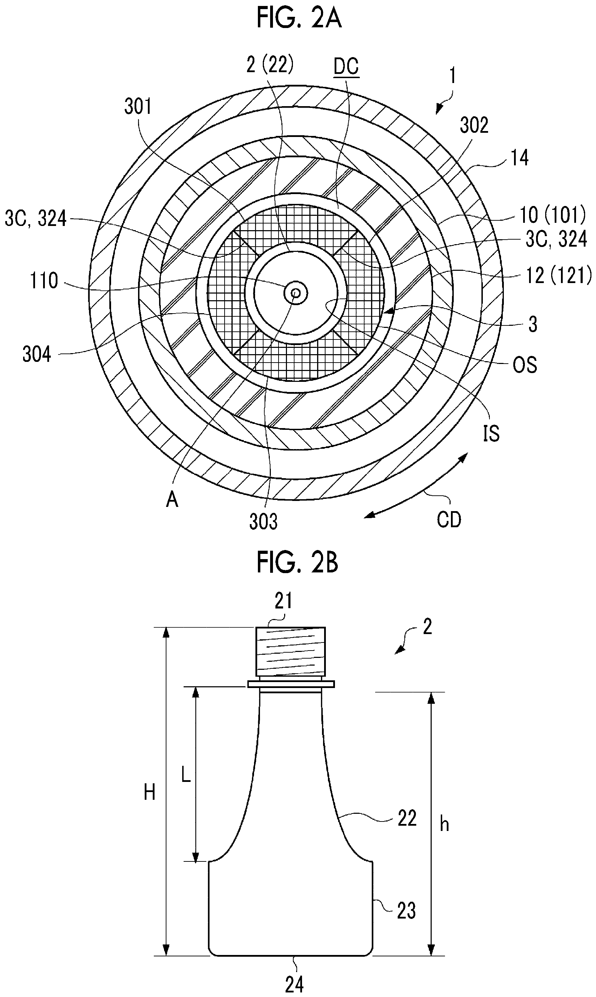

The shape of the container 2 shown in Fig. 1 is merely an example. As shown in Fig. 2B, the film-forming device 1 is particularly effective for forming a barrier film on a container in which a dimension L of the neck portion 22 or a small diameter portion adjacent to the neck portion 22 (a region having a smaller dimension in a radial direction than that of the body portion 23) in the height direction is 1/3 or more of a dimension H of the entire container in the height direction or 1/2 or more of an effective film formation dimension h in the height direction.

[Configuration of Film-Forming Device]

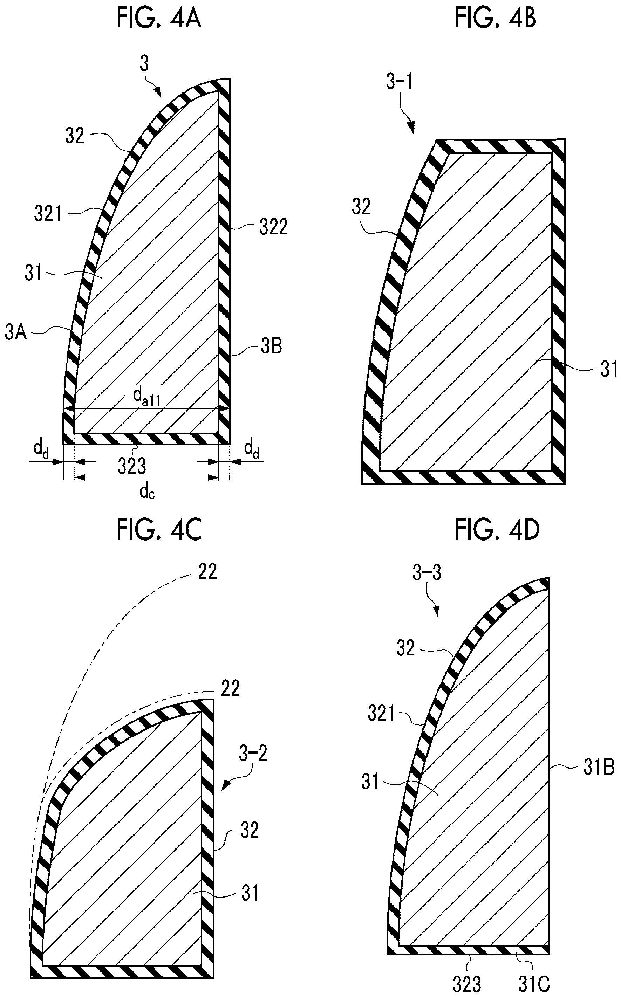

As shown in an example of the configuration in Figs. 1 and 2A, the film-forming device 1 includes the external electrode 10 that is disposed outside the container 2, an internal electrode 11 that is disposed inside the container 2, a first dielectric member 12 that is provided inside the external electrode 10, an exhaust unit 13 that exhausts a space where the container 2 is disposed, a shield member 14 that surrounds the external electrode 10, the auxiliary tool 3 (Fig. 4A) that includes a conductor portion 31 and a second dielectric portion 32, and a grip tool 15 that grips the container 2. The film-forming device 1 performs a film formation treatment on the container 2 in an inverted posture with the mouth portion 21 facing downward.

(External Electrode)

The external electrode 10 is formed in a shape surrounding a space required for the film formation of the container 2, for example, of a metallic material, such as copper and aluminum, or a conductive material such as carbon. The external electrode 10 is connected to a matching device 162 and a high-frequency power supply 17 through an electrical wire connected to a connector 161.

The high-frequency power supply 17 (alternating electric field source) applies a high-frequency alternating electric field between the external electrode 10 and the grounded internal electrode 11. The internal electrode 11 may be connected to the matching device 162 and the high-frequency power supply 17, and the external electrode 10 may be grounded.

An output of the high-frequency power supply 17 is, for example, 100 to 1,000 W, and a frequency band of the alternating electric field caused by the high-frequency power supply 17 is, for example, 13.56 MHz to 100 MHz. It is also possible to adopt a lower frequency or a higher frequency than this frequency band.

The external electrode 10 also functions as a chamber for accommodating the container 2 supplied to the film-forming device 1 by a transport device (not shown) inside and holding the decompressed space inside. The external electrode 10, the first dielectric member 12, the auxiliary tool 3, and the container 2 are disposed concentrically as shown in Fig. 2A.

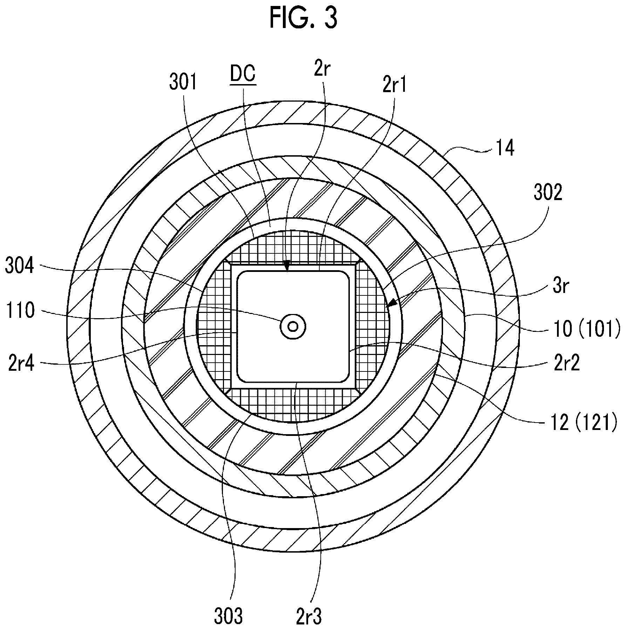

A cross section of the container 2 is not limited to a circular shape and may be a substantially rectangular shape as in a container 2r shown in Fig. 3. In this case, it is preferable that the shape of an auxiliary tool 3r is also a shape having four flat surfaces facing side surfaces 2r1 to 2r4 in accordance with the shape of the rectangular container 2r.

The external electrode 10 consists of a cylindrical peripheral wall 101 and an upper wall 102 that is continuous to an upper end of the peripheral wall 101. An inner peripheral portion of the peripheral wall 101 is formed on a cylindrical surface.

The external electrode 10 is configured to be movable in an up-down direction z with respect to a position of the container 2 by an elevating mechanism (not shown). In addition, an assembly 19 is configured to be movable in the up-down direction z with respect to the position of the container 2 by the elevating mechanism (not shown). The assembly 19 includes insulating members 191 to 194, the exhaust unit 13, and the internal electrode 11 supported by the insulating member 194.

By raising and lowering the external electrode 10, an opening 103 in a lower end of the external electrode 10 is opened and closed. In addition, the assembly 19 is raised and lowered to insert the internal electrode 11 into the container 2.

When the external electrode 10 is lowered to the position shown in Fig. 1, the container 2 is accommodated inside the external electrode 10 from the bottom portion 24, and the opening 103 is closed. When the assembly 19 is raised to the position shown in Fig. 1, the internal electrode 11 is inserted into the container 2.

The opening 103 is air-tightly closed by the insulating members 191 and 192 or the like. A seal member (not shown) is disposed between the lower end of the external electrode 10 and the insulating member 191 as necessary.

(Internal Electrode)

The internal electrode 11 is formed of, for example, a conductive material having heat resistance, such as tungsten and stainless steel, and is inserted into the container 2 accommodated inside the external electrode 10. The internal electrode 11 is formed in a tubular shape and also serves as an introduction pipe for a gas containing a raw material for a barrier film. A raw material gas (not shown) of the barrier film is introduced from a supply source for the raw material gas into the internal electrode 11 and fills the inside of the container 2. In a case where the barrier film is a DLC film, the raw material gas is, for example, acetylene.

In a case where an introduction portion of a gas is provided in the film-forming device 1 in addition to the internal electrode 11, the internal electrode 11 does not need to have a tubular shape and may have, for example, a rod shape. In this case, a gas introduction portion through which a raw material gas is introduced into the container 2 does not need to be inserted into the container 2.

A cylindrical dielectric 110 is provided at a tip of the internal electrode 11 in order to avoid local concentration of plasma.

(First Dielectric Member)

The first dielectric member 12 (existing dielectric member) is a member of a dielectric formed of, for example, a dielectric material such as a resin and a ceramic. The first dielectric member 12 is provided inside the external electrode 10 in order to suppress occurrence of abnormal discharge and to uniformly form a barrier film when an electric field is applied between the external electrode 10 and the internal electrode 11. Unlike the auxiliary tool 3, the first dielectric member 12 is provided in advance in the external electrode 10 before the film-coated container is manufactured by the film-forming device 1.

The first dielectric member 12 also consists of a cylindrical peripheral wall 121 and an upper wall 122 that is continuous to an upper end of the peripheral wall 121, similarly to the external electrode 10. An inner peripheral portion of the peripheral wall 121 is formed on a cylindrical surface.

Since an inner surface of the external electrode 10 is covered with the first dielectric member 12, occurrence of abnormal discharge in which an energy level locally stands out due to electrons flying from the external electrode 10 during application of a high-frequency electric field is suppressed.

Even when the first dielectric member 12 exists between the external electrode 10 and the container 2, a displacement current flows in the first dielectric member 12 due to application of an alternating electric field. Similarly, since the displacement current flows also in the container 2, which is a dielectric, a high-frequency electric field can be applied between the external electrode 10 and the internal electrode 11 via the first dielectric member 12 and the container 2 to generate plasma.

The first dielectric member 12 can be formed of an appropriate material having dielectricity. Based on the dielectricity, the first dielectric member 12 functions as an insulator without a current flowing during application of a direct current electric field, and a displacement current flows during application of an alternating electric field.

In addition, it is preferable that the first dielectric member 12 is formed of a material particularly having a small dielectric loss in a high-frequency electric field, high heat resistance, flame retardance, and mechanical strength. For this reason, for example, a resin material such as polytetrafluoroethylene (PTFE), perfluoroalkoxyalkane (PFA), rigid polyvinyl chloride, polycarbonate, and polyether ether ketone (PEEK) or a ceramic material such as aluminum oxide (alumina) and steatite can be adopted. The first dielectric member 12 of the present embodiment is formed of PTFE.

When the container 2 is accommodated inside the external electrode 10, the first dielectric member 12 faces the body portion 23 and the bottom portion 24 of the container 2. A gap between the peripheral wall 121 and the body portion 23 and a gap between the upper wall 122 and the bottom portion 24 are allowed. Dimensions of these gaps change depending on dimensions and a shape of the container 2.

(Exhaust Unit)

The exhaust unit 13 is insulated from the external electrode 10 by the insulating members 191 and 192 or the like and is connected to a vacuum suction device 18 including a vacuum pump, a vacuum tank, and the like. When a raw material gas is blown out from the internal electrode 11 while exhausting a space inside the external electrode 10 through a flow path 13A of the exhaust unit 13 in a state where the opening 103 of the external electrode 10 is closed, a space, which is depressurized to a predetermined degree of vacuum, is provided inside and in the surroundings of the container 2. The pressure of the decompressed space is, for example, 0.1 to 1 Torr.

(Shield Member)

The shield member 14 functions as an electromagnetic shield that prevents emission of electromagnetic waves and a high-frequency ground. The shield member 14 is formed, for example, in a cylindrical shape of a conductive material such as aluminum, stainless steel, copper, and brass. The shield member 14 covers the entire external electrode 10 in a state of being insulated from the external electrode 10 and is grounded. The shield member 14 is supported by the external electrode 10 via an insulating member 141 and is raised and lowered together with the external electrode 10.

The shield member 14 may be configured as a chamber that provides a decompressed space in the surroundings of the container 2 instead of the external electrode 10.

(Grip Tool)

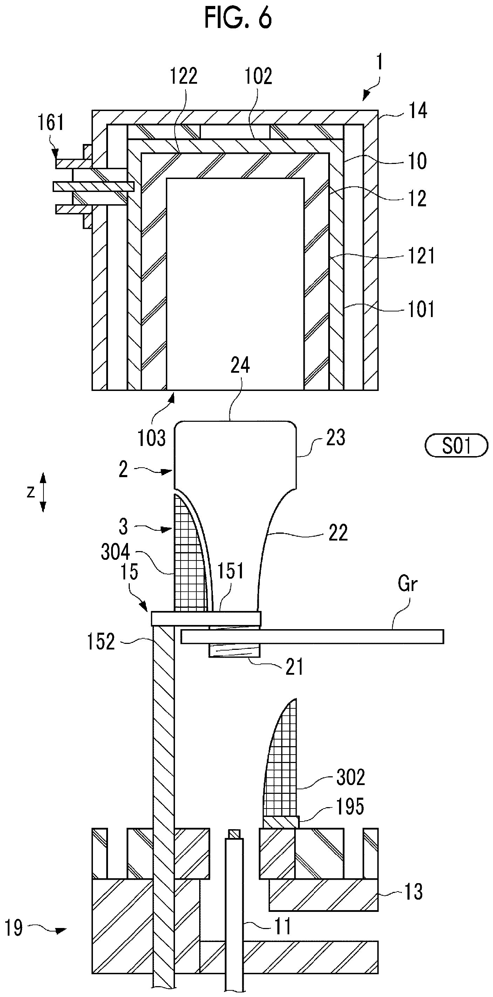

The grip tool 15 receives the container 2 from a grip tool Gr (Fig. 6) of the transport device (not shown) and supports the container 2 in the space inside the external electrode 10 while the film formation treatment is performed on the container 2.

The grip tool 15 includes a gripper 151 that grips the neck portion 22 of the container 2 and a support member 152 that supports the gripper 151 and that penetrates the insulating member 193. The assembly 19 described above is raised and lowered with respect to the grip tool 15.

In order to avoid local concentration of plasma in a space where the film formation treatment is performed, the gripper 151 is a dielectric and is made of a resin material or the like. The gripper 151 includes a pair of grip claws (not shown) that is configured to be openable and closable.

A flange (not shown) of the neck portion 22 of the container 2 is supported by the gripper 151. The auxiliary tool 3 is disposed around the container 2 supported by the gripper 151. The gripper 151 is configured to be capable of attaching the auxiliary tool 3.

[Configuration of Auxiliary Tool for Film Formation]

Next, a configuration of the auxiliary tool 3 including the conductor portion 31 and the second dielectric portion 32 will be described. The auxiliary tool 3 is disposed between the external electrode 10 and the container 2 during the film formation treatment, thereby imparting sufficient gas barrier properties to the container 2. The auxiliary tool 3 is inserted into the external electrode 10 in a state of being disposed around the container 2. The auxiliary tool 3 is attached to the gripper 151 to protrude upward from the gripper 151. Since the auxiliary tool 3 is supported by the gripper 151, when the container 2 gripped by the gripper 151 is accommodated inside the external electrode 10, the auxiliary tool 3 is also accommodated inside the external electrode 10 together with the container 2.

According to the example shown in Fig. 1, the auxiliary tool 3 is disposed between the neck portion 22 of the container 2 and the first dielectric member 12. It is preferable that the auxiliary tool 3 is formed in a shape that follows the shape of the curved neck portion 22 in side view and the shape of an inner peripheral portion of the first dielectric member 12, and a gap formed between the neck portion 22 and the first dielectric member 12 is generally filled when the auxiliary tool 3 is not disposed. For this reason, the auxiliary tool 3 has a facing surface 3A that is curved in a vertical section and that faces the neck portion 22, and a back surface 3B that is linear in the vertical section and that faces the first dielectric member 12.

The auxiliary tool 3 has a tubular shape as a whole, and a shape suitable for an outer shape of the container 2, which is a specific product, is given to an inner peripheral portion thereof. The shape of the auxiliary tool 3 does not need to exactly correspond to the shape of the neck portion 22. The existence of a gap is allowed between the auxiliary tool 3 and the neck portion 22 and between the auxiliary tool 3 and the first dielectric member 12.

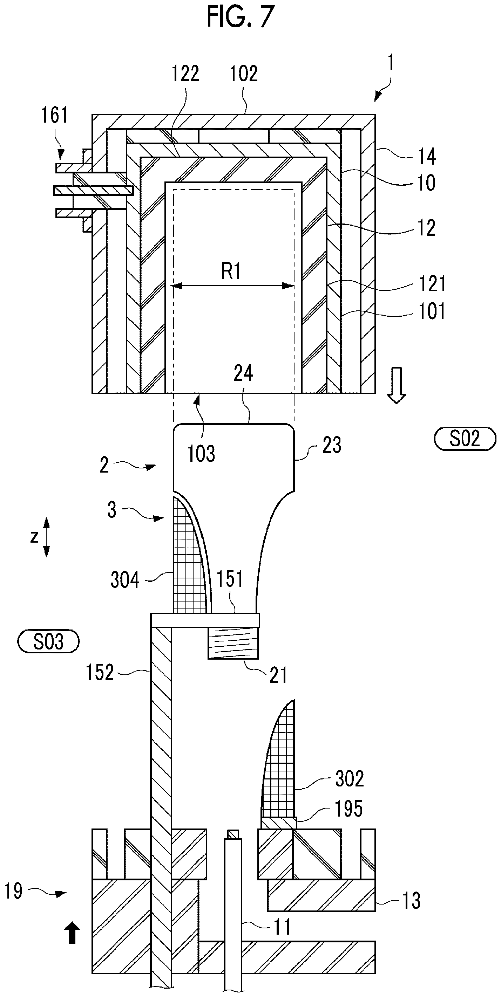

When the auxiliary tool 3 is disposed around the container 2, the back surface 3B of the auxiliary tool 3 is positioned at the same position as the position of an outer peripheral surface of the body portion 23 of the container 2 or is positioned on a radial inner side of the container 2 with respect to the position. As shown in Fig. 7, the external electrode 10 and the first dielectric member 12 do not exist in a projection region R1 when the container 2 and the auxiliary tool 3 are projected in the up-down direction z toward the external electrode 10. For this reason, when the external electrode 10 is lowered to accommodate the container 2 inside the external electrode 10, the auxiliary tool 3 is inserted inside the external electrode 10 without interfering with the external electrode 10 and the first dielectric member 12.

For example, as shown in Fig. 4A, the auxiliary tool 3 includes the block-shaped conductor portion 31 and the second dielectric portion 32, which is a coating film covering a surface of the conductor portion 31.

A volume proportion of the conductor portion 31 to the entire auxiliary tool 3 is approximately 100%.

The second dielectric portion 32 shown in Fig. 4A is provided over the entire surface of the first conductor portion 31. The second dielectric portion 32 has a first region 321 that forms the facing surface 3A facing the container 2, a second region 322 that forms the back surface 3B facing the external electrode 10, and a third region 323 facing the gripper 151. The second dielectric portion 32 is not shown in Fig. 4A, but as shown in Fig. 2A, has fourth regions 324 on side surfaces 3C on both sides in a circumferential direction CD. In Fig. 2A, the fourth region 324 is shown only for a segment 301, but the fourth regions 324 are also provided for segments 302 to 304. The second dielectric portion 32 covers the entire surface of the first conductor portion 31 by including the first region 321, the second region 322, the third region 323, and the fourth regions 324.

A relationship between the second dielectric portion 32 and the conductor portion 31, and the external electrode 10 and the first dielectric member 12 when the auxiliary tool 3 is inserted into the external electrode 10 is as follows.

The first region 321 of the second dielectric portion 32 faces an outer surface of the neck portion 22 of the container 2, and the second region 322 of the second dielectric portion 32 faces a side of the peripheral wall 101 of the external electrode 10. The peripheral wall 121 of the first dielectric member 12 is interposed between the second region 322 and the peripheral wall 101.

The conductor portion 31 faces a side of the neck portion 22 of the container 2 with the first region 321 of the second dielectric portion 32 interposed therebetween. In addition, the conductor portion 31 faces a side of the peripheral wall 121 of the first dielectric member 12 with the second region 322 of the second dielectric portion 32 interposed therebetween.

The conductor portion 31 is formed of a metallic material, such as aluminum, an aluminum alloy, copper, and a copper alloy, or a material having conductivity such as carbon.

The second dielectric portion 32 is formed of a dielectric material such as a resin and a ceramic. The second dielectric portion 32 can be formed of, for example, the material described above that can be used for the first dielectric member 12. The second dielectric portion 32 of the present embodiment is formed of PTFE, similarly to the first dielectric member 12. A material for the first dielectric member 12 and a material for the second dielectric portion 32 may be different from each other.

The auxiliary tool 3 is produced, for example, by applying a coating of PTFE, which is the second dielectric portion 32, to the surface of the first conductor portion 31 made of aluminum and molded by cutting or the like. This coating is performed by adhering powder of PTFE to the surface of the first conductor portion 31 using a spray gun, an electrostatic powder coating machine, or the like and forming a coating film on the surface of the first conductor portion 31 with PTFE softened by a heating treatment. The second dielectric portion 32 is formed to have a substantially uniform thickness. A film thickness of the second dielectric portion 32 is, for example, 10 to 150 μm and preferably approximately 30 to 70 μm.

Instead of coating of PTFE, an alumite treatment can also be performed on the conductor portion 31 made of aluminum. Through the alumite treatment, a coating film of aluminum oxide is formed on the surface of the conductor portion 31, and the aluminum oxide is a dielectric. The coating film of the aluminum oxide corresponds to the second dielectric portion 32.

As shown in Fig. 2A, the auxiliary tool 3 consists of two or more segments 301 to 304 arranged around the container 2. That is, the auxiliary tool 3 is divided into n (n ≤ 2) segments in the circumferential direction of the container 2. The auxiliary tool 3 of Fig. 2A is divided into four segments of which each central angle is 90°. The auxiliary tool 3 does not necessarily have to be divided into equal angles. It is preferable that the segments 301 to 304 are disposed to surround the container 2 over the entire periphery.

Each of the segments 301 to 304 can be produced, for example, by applying a coating of PTFE, which is the second dielectric portion 32, to the surface of the first conductor portion 31 made of aluminum, which is molded by cutting or the like.

As being divided into the plurality of segments 301 to 304, the auxiliary tool 3 can be disposed around the container 2 without transferring the container 2 from the gripper 151 to another holding mechanism.

In the present embodiment, the segment 302 that is separated from the other segments 301, 303, and 304 at the time of the delivery of the container 2 from the grip tool Gr to the gripper 151 is attached to the assembly 19 which a support supporting the internal electrode 11 via the insulating member 195. The segments 301, 303, and 304 are attached to the gripper 151.

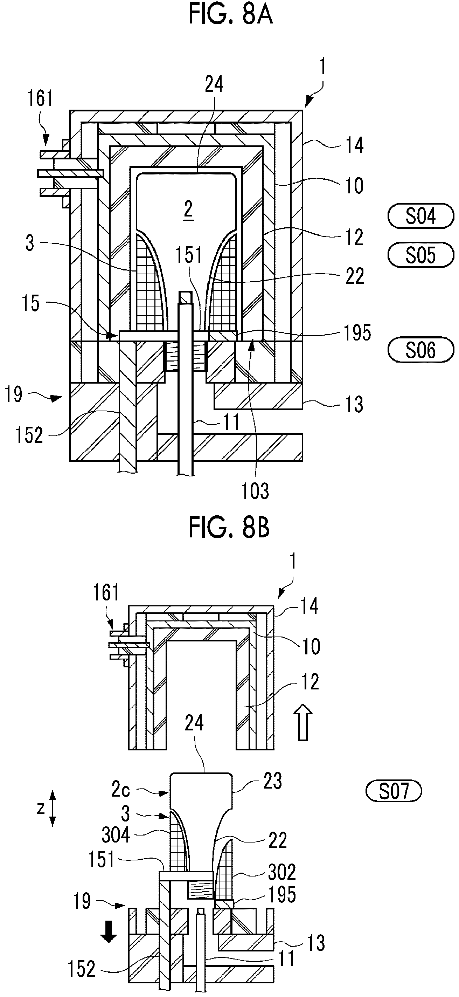

When the container 2 is received by the gripper 151 from the grip tool Gr, the segment 302 (separated segment) is retracted to a position separated from the grip tools Gr and 15 and the container 2 (see Fig. 6). When the assembly 19 is moved toward the container 2 (Figs. 7 and 8A) after the container 2 is received by the gripper 151, all the segments 301 to 304 are disposed around the container 2.

In the example in which the auxiliary tool 3 is disposed around the container 2 as described above, the segments 301, 303, and 304 may be combined, and the portions may be integrally formed. That is, the auxiliary tool 3 may be divided into two segments including a segment, in which the segments 301, 303, and 304 are integrated, and the segment 302.

When the auxiliary tool 3 can be disposed around the neck portion 22 of the container 2, the auxiliary tool 3 can be formed in an integral tubular shape that is connected in the circumferential direction without being divided in the circumferential direction. For example, when the container 2 in an inverted posture is inserted from above into the tubular auxiliary tool 3, the auxiliary tool 3 is disposed around the neck portion 22.

The auxiliary tool 3 shown in Fig. 4A is disposed over the entire length of the neck portion 22 of the container 2 in the height direction, but the auxiliary tool 3 in the present disclosure is not limited thereto. As in the case of an auxiliary tool 3-1 shown in Fig. 4B, a shape in which a side close to the body portion 23 is missing from the shape shown in Fig. 4A may be adopted.

In a case where a barrier film is formed by the film-forming device 1 on the containers 2 having different shapes corresponding to a plurality of types of products, it is preferable that a plurality of types of film forming auxiliary tools suitable for the different container shapes are prepared. In this case, an auxiliary tool for film formation is selected according to a container shape of a product to be manufactured. For this reason, it is preferable that the auxiliary tool 3 is attachably and detachably attached to the gripper 151 and the insulating member 195.

The auxiliary tool 3 is not necessarily limited to being used only in the film formation treatment of the container 2, which is a single product, and can also be used in the film formation treatment of containers, which are two or more different products.

For example, an auxiliary tool 3-2 shown in Fig. 4C can be used in both a container having the neck portion 22 indicated by a two-dot chain line and a container having the neck portion 22 indicated by a one-dot chain line.

In order to suppress occurrence of abnormal discharge, it is sufficient for the second dielectric portion 32 to include at least only the first region 321 facing the neck portion 22 of the container 2. For example, as in the case of an auxiliary tool 3-3 shown in Fig. 4D, since the second dielectric portion 32 includes only the first region 321 and the third region 323, a back surface 31B of the conductor portion 31 may be exposed.

In the present embodiment, when the auxiliary tool 3 is disposed in a film forming chamber DC of the film-forming device 1, the external electrode 10, the first dielectric member 12, the auxiliary tool 3, and the container 2 are disposed in this order in a radial direction rd of the film forming chamber DC in which the internal electrode 11 is disposed from the side of the external electrode 10 toward the axis A.

The conductor portion 31 and the second dielectric portion 32 of the auxiliary tool 3 will be focused. In the case of the auxiliary tool 3 shown in Fig. 4A, similarly, the external electrode 10, the first dielectric member 12, the second dielectric portion 32 (second region 322), the conductor portion 31, and the second dielectric portion 32 (first region 321) are arranged in this order. In addition, in the case of the auxiliary tool 3-3 shown in Fig. 4A, similarly, the external electrode 10, the first dielectric member 12, the conductor portion 31, and the second dielectric portion 31 (first region 321) are arranged in this order. When at least the arrangement by the auxiliary tool 3-3 is adopted, occurrence of abnormal discharge can be suppressed, but when the arrangement by the auxiliary tool 3 is adopted, an effect of suppressing the occurrence of abnormal discharge is large.

The film forming auxiliary tool 3 in which the segments 301 to 304 are combined is made of a conductive material and includes the tubular conductor portion 31 having an inner peripheral surface IS and an outer peripheral surface OS (Fig. 2A) and the dielectric portion 32 (first region 321) covering at least the inner peripheral surface IS of the conductor portion 31. In a case of including the second region 322, the dielectric portion 32 is included also on the outer peripheral surface OS.

[Manufacturing Procedures of Film-Coated Container]

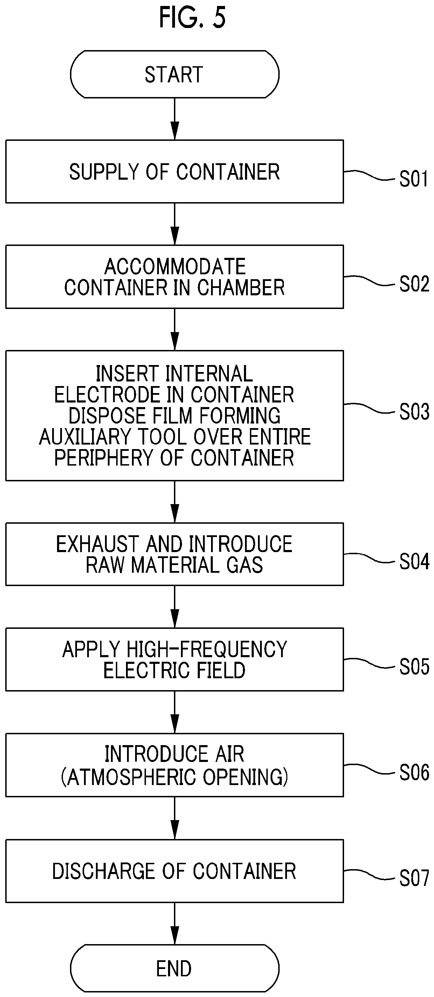

An example of procedures for manufacturing a container 2c to which a barrier film is applied will be described with reference to Figs. 5 to 8B.

As shown in Fig. 6, a series of treatments from receiving of the container 2 (S01) to discharging of the film-coated container 2c, to which the barrier film is applied, from the film-forming device 1 as shown in Fig. 8B (S07) are repeatedly performed at a predetermined cycle time.

As shown in Fig. 6, the container 2 supplied to the film-forming device 1 by the grip tool Gr of the transport device (not shown) is received by the grip tool 15 (container supply step S01). At this time, only the segments 301, 303, and 304 attached to the gripper 151 are disposed around the neck portion 22 of the container 2, and the segment 302 is retracted downward from the container 2. For this reason, a space between the pair of grip claws (not shown) of the gripper 151 is open over the central angle (90°) of the segment 302 that is absent around the container 2. At this time, the neck portion 22 of the container 2 is inserted between the pair of grip claws from the gap that exists at the position of the segment 302 shown in Fig. 2. When the pair of grip claws is closed by a drive mechanism (not shown), the neck portion 22 is gripped by the gripper 151. That is, the segments 301 to 304 are configured such that the container 2 can be delivered from the grip tool Gr to the gripper 151 by appropriately determining respective phases and central angles of the segments 301 to 304 in the surroundings of the container 2.

Next, as shown in Fig. 7, the external electrode 10 is lowered toward the container 2 to accommodate the container 2 in a space formed between the external electrode 10 and the assembly 19 (container accommodating step S02). In parallel with this, the assembly 19 is raised toward the container 2 to insert the internal electrode 11 into the container 2 (internal electrode inserting and auxiliary tool disposing step S03).

With the insertion of the internal electrode 11, the segment 302 supported by the assembly 19 together with the internal electrode 11 rises and is inserted into a gap between the segment 301 and the segment 303 in the circumferential direction.

When the opening 103 of the external electrode 10 is closed by the rise of the assembly 19, all the segments 301 to 304 are disposed around the neck portion 22 of the container 2 (Fig. 8A).

As shown in Fig. 8A, the film formation treatment is performed on the container 2 accommodated inside the external electrode 10 according to the following procedures. When the film formation treatment is performed on the container 2 in an inverted posture, dust or the like that has not been deposited on the container 2 is likely to be discharged from the mouth portion 21 of the container 2 due to its own weight.

A space between the external electrode 10 and the assembly 19 is exhausted through the exhaust unit 13, and a raw material gas is introduced into the container 2 through the internal electrode 11 (exhausting and raw material gas introducing step S04).

In a state where the space of the chamber is depressurized to a predetermined degree of vacuum by the exhaust, an alternating electric field is applied between the external electrode 10 and the internal electrode 11 for a predetermined time (for example, approximately several seconds) by the high-frequency power supply 17 (electric field applying step S05). Discharge occurs from the external electrode 10 toward the internal electrode 11 by applying a high-frequency electric field. The raw material gas is decomposed and ionized as plasma is generated due to the discharge, and the ions accelerated by the electric field collide with the inner surface of the container 2, thereby a barrier film is formed.

By disposing the first dielectric member 12 and the second dielectric portion 32 between the external electrode 10 and the internal electrode 11, occurrence of abnormal discharge, which can cause damage to the barrier film and the container 2, is suppressed.

When the film formation on the container 2 is completed, air is introduced into the chamber space through a path (not shown) (atmospheric opening step S06).

After then, as shown in Fig. 8B, the external electrode 10 is raised to open the opening 103, and the assembly 19 is lowered to pull out the internal electrode 11 from the film-coated container 2c. Then, by retracting at least one of the segments 301 to 304 from the neck portion 22, the film-coated container 2c can be discharged. The film-coated container 2c is passed from the grip tool 15 to a grip tool (not shown) and is discharged from the film-forming device 1 (container discharge step S07).

As described above, the manufacturing of the film-coated container 2c having the barrier film is completed.

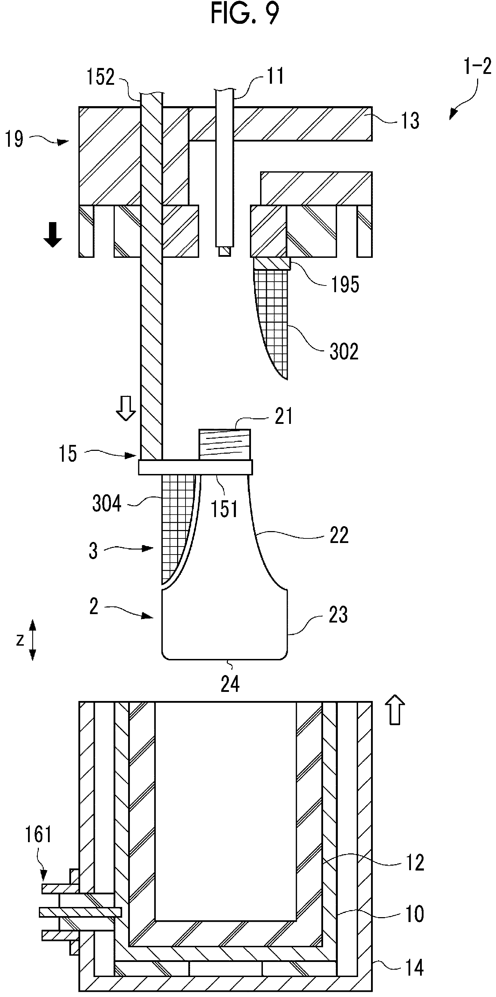

As shown in Fig. 9, it is also possible to perform the film formation treatment on the container 2 gripped in an upright posture. A film-forming device 1-2 shown in Fig. 9 has a configuration where the film-forming device 1 shown in Fig. 1 is upside down. Among the segments 301 to 304, the segments 301, 303, and 304 are supported by the gripper 151 in a state of being suspended downward from the gripper 151. The remaining segment 302 is supported similarly to the assembly 19. The segment 302 is separated from the segments 301, 303, and 304 until the internal electrode 11 is inserted into the container 2.

[Action of Film Forming Auxiliary Tool]

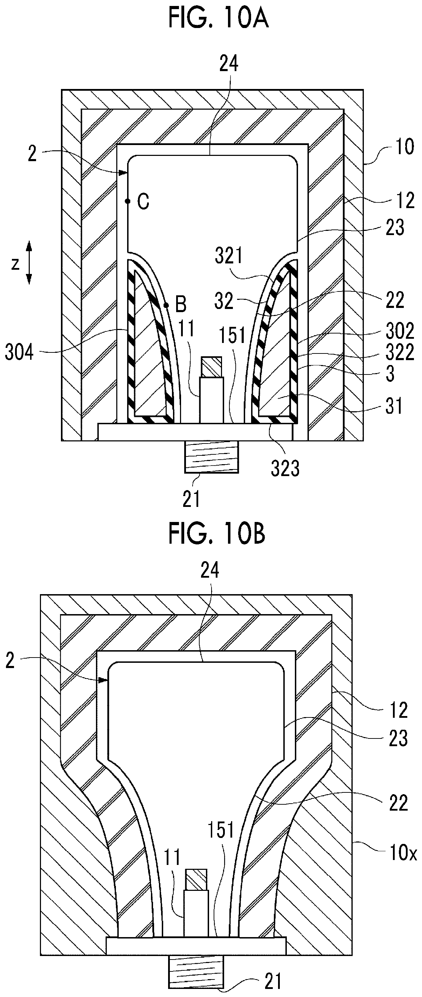

Action of the auxiliary tool 3 will be described with reference to Figs. 10A and 10B.

The auxiliary tool 3 is a separate body from the external electrode 10 and the first dielectric member 12 already provided in the external electrode 10. For this reason, the auxiliary tool 3 can be disposed in the film forming chamber DC inside the external electrode 10 and the first dielectric member 12 and around the neck portion 22 that is thinner than the body portion 23 of the container 2. The auxiliary tool 3 disposed around the neck portion 22 is inserted along the up-down direction z into the external electrode 10 and the first dielectric member 12 together with the container 2 without interfering with the external electrode 10 and the first dielectric member 12, all of which are formed in a cylindrical shape.

At this time, in the radial direction rd, substantially the entire space between the container 2 and the first dielectric member 12 is occupied by the conductor portion 31 except for the second dielectric portion 32, which is a surface layer of the auxiliary tool 3. Then, it is as if the conductor portion 31 constitutes a part of the external electrode 10, and the thickness of an external electrode 10x is increased toward the inside in the radial direction rd as shown in Fig. 10B, which is substantially the same as a case where the external electrode 10x approaches around the container 2. That is, by using the auxiliary tool 3, a conductive region of the external electrode 10 (Fig. 10A) can be practically expanded to a conductive region of the external electrode 10x.

Even when the auxiliary tool 3 is disposed around the container 2 and the region of the external electrode 10 is enlarged to a position close to the container 2, a distance from a conductor (the conductor portion 31 and the external electrode 10x) to the container 2 is smaller than a distance from the inner peripheral portion of the first dielectric member 12 to the container 2. For this reason, in any case, gas barrier properties are improved.

However, as shown in Fig. 10B, it is assumed that the region of the external electrode 10x is expanded inward. In this case, even when the container 2 is inserted into the external electrode 10x from a bottom portion 24 side, the container 2 interferes with the external electrode 10x and the first dielectric member 12. Therefore, since the container 2 cannot be accommodated inside the external electrode 10x, the film formation treatment using the external electrode 10x is not established.

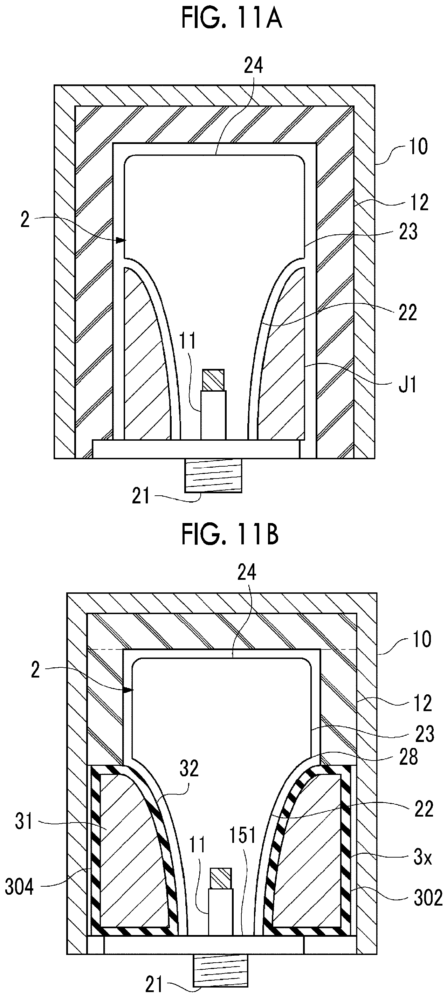

As shown in Fig. 11A, it is assumed that an auxiliary tool J1 having the same shape and dimensions as those of the auxiliary tool 3 and consisting of only a conductor, which is a separate body from the external electrode 10, is disposed around the neck portion 22, instead of the auxiliary tool 3. In this case, the container 2 and the auxiliary tool J1 can be accommodated inside the external electrode 10. However, since a surface of the auxiliary tool J1 is not covered with a dielectric, electrons may fly from the auxiliary tool J1 during application of a high-frequency electric field, and as a result, abnormal discharge can occur.

As in an auxiliary tool 3x shown in Fig. 11B, the region may be expanded to the outside of the container 2 in the radial direction. Since an outer diameter of the auxiliary tool 3x is smaller than an inner diameter of the external electrode 10, the container 2 and the auxiliary tool 3x can be accommodated inside the external electrode 10 without any problem.

Further, the region of the auxiliary tool 3x may be expanded beyond a position of a shoulder 28 of the container 2 to a position indicated by a two-dot chain line in Fig. 11B. At this time, the first dielectric member 12 faces the bottom portion 24 of the container 2.

By using the auxiliary tool 3, a distance from the conductor portion 31 to the container 2 is small, so that energy density of electrons, ions, and radicals in plasma increases, and the ions and radicals derived from a raw material gas collide with the inner surface of the container 2 with sufficient energy. As a result, film quality of a barrier film formed on the inner surface of the neck portion 22 is improved, and the film thickness of the barrier film is increased, so that gas barrier properties of the neck portion 22 where the auxiliary tool 3 is disposed is improved.

Moreover, since the second dielectric portion 32 exists in the auxiliary tool 3, occurrence of abnormal discharge attributable to the flying of the electrons released from the external electrode 10 to the chamber space can be suppressed. Since the second dielectric portion 32 is a thin coating film, a material having a low dielectric loss at a high frequency is selected, and thus energy of a high-frequency electric field is hardly attenuated.

Hereinafter, a case where a barrier film is formed on the container 2 without using the auxiliary tool 3 will be described with reference to a basic concept of gas barrier properties.

When the auxiliary tool 3 is not used in film formation of the container 2, and thus a large gap is formed between the neck portion 22 and the first dielectric member 12, gas barrier properties of the barrier film formed on the container 2 in this state are insufficient for a required level. Even in a case where an auxiliary tool that has the same shape as that of the auxiliary tool 3 and that consists of a dielectric, which is a separate body from the first dielectric member 12, is disposed around the neck portion 22, instead of the auxiliary tool 3, the gas barrier properties do not reach the required level due to the dielectric loss of the thick dielectric.

This has been confirmed by a comparative example of film formation test results to be described later.

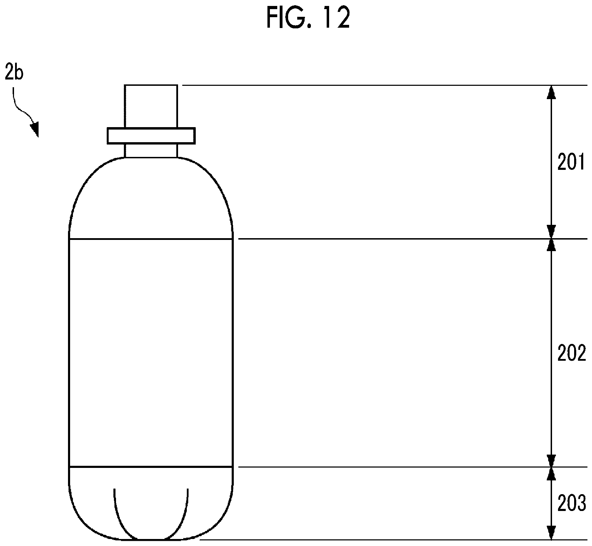

The reason why the container 2 of the present embodiment is disadvantageous from a viewpoint of gas barrier properties is that the length of the narrow neck portion 22 is excessively long with a container 2b, which is a typical resin beverage bottle shown in Fig. 12, as reference. A length L (Fig. 2B) of the neck portion 22 of the container 2 in the height direction extends to 1/2 or more of the height H of the entire container 2. In addition, the length L of the neck portion 22 in the height direction is approximately 2/3 of the effective film formation height h disposed in the decompressed space above the gripper 151.

The gas barrier properties deteriorate as a distance from the external electrode 10 to the container 2 increases. The gas barrier properties of the neck portion 22, which is farthest from the inner peripheral surface of the cylindrical external electrode 10, are inferior to the gas barrier properties of the body portion 23, which is closest to the inner peripheral surface of the external electrode 10, even when a spacer of a dielectric is disposed around the neck portion 22.

As described above, the neck portion 22 of the container 2 occupies 1/2 or more of the height H of the container 2. With the neck portion 22 occupying such a wide range of the container 2 to this extent, even when the body portion 23 having good gas barrier properties exists, gas barrier properties of the container 2, which is the sum of the gas barrier properties of the respective regions, deteriorate.

That is, in order to improve the gas barrier properties of the container 2, it is important to improve gas barrier properties of a region having a large proportion of the surface area to the entire container and having poor gas barrier properties. A calculation example for confirming this will be described later.

(Basic Concept of Gas Barrier Properties)

The basic concept of gas barrier properties will be described. The "gas barrier properties" are typically evaluated by the oxygen permeability per one container 2. The oxygen permeability is typically measured using a MOCON method (oxygen permeability measurement).

In a case where the oxygen permeability of the container 2 per unit area is uniform, the oxygen permeability of the entire container 2 is represented by the following equation.

$$[\text{Oxygen permeability per unit area}] \times [\text{surface area of container}]$$

In a case where the oxygen permeability varies depending on the region of the container 2, oxygen permeability B of the entire container 2 can be represented as a sum of the oxygen permeabilities of the respective regions as in equation (1). In equation (1), $b_i$ is oxygen permeability in a region i, and $S_i$ is the surface area of the region i.

$$B = \sum (b_i \times S_i) \qquad \cdots \quad (1)$$

With reference to the typical beverage container 2b shown in Fig. 12, a relationship between gas barrier properties of each region of the container 2b and the gas barrier properties of the entire container 2b will be considered.

When the oxygen permeability of the uncoated container 2b is uniform in the entire container 2b, oxygen permeability b of the container 2b per unit area is represented by equation (2) below. In equation (2), S and B mean the followings.

S: surface area of entire container 2b
B: oxygen permeability of entire uncoated container 2b (before barrier film formation)

$$b = \frac{B}{S} \quad \cdots \quad (2)$$

As shown in Fig. 12, it is assumed that the bottle 2b is divided into three regions 201 to 203.

Herein, when surface areas of the regions 201 to 203 of the container 2b are denoted by $S_1$, $S_2$, and $S_3$, respectively, the surface areas can be represented as in equation (3) below.

$$S = S_1 + S_2 + S_3 \quad \cdots \quad (3)$$

It is assumed that the surface areas of the regions 201, 202, and 203 are, for example, $S_1 = 0.3S$, $S_2 = 0.5S$, and $S_3 = 0.2S$, respectively.

The total surface area of the surface area $S_1$ of the region 201 and the surface area $S_3$ of the region 203 corresponds to 1/2 of the surface area of the entire container 2b.

The oxygen permeabilities of the regions 201 to 203 after barrier film formation are denoted by $b_1$, $b_2$, and $b_3$, respectively.

When the oxygen permeability of the entire container 2b after the barrier film formation is denoted by B', the oxygen permeability can be represented as in equation (4) below.

$$B' = b_1 \times S_1 + b_2 \times S_2 + b_3 \times S_3 \quad \cdots \quad (4)$$

A barrier improvement factor (BIF) at that time is represented by equation (5) below. The BIF corresponds to "gas barrier properties".

$$BIF = \frac{B}{B'} \quad \cdots \quad (5)$$

In order to confirm a relationship between the quality of gas barrier properties of each region of the container and an area proportion, CASE 1 and CASE 2 are assumed as shown in the following table, and table 1 shows an example of calculation of a change in the overall oxygen permeability when the oxygen permeability of each of the regions 201 to 203 changes. Calculation is made assuming S = 1 and B = 1.

[Table 1]

| Table 1: Calculation example of overall oxygen permeability when oxygen permeability of each portion changes and gas barrier properties | | | | | |
|---|---|---|---|---|---|
| | | CASE 1 | | CASE 2 | |
| Region of container | Surface area | Oxygen permeability after film formation | Oxygen permeability per region | Oxygen permeability after film formation | Oxygen permeability per region |
| Region 201 | $S_1 = 0.3S$ | $b_1 = 1/5\ b$ | $S_1 \times b_1 = 0.060$ | $b_1 = 1/10\ b$ | $S_1 \times b_1 = 0.030$ |
| Region 202 | $S_2 = 0.5S$ | $b_2 = 1/20\ b$ | $S_2 \times b_2 = 0.025$ | $b_2 = 1/18\ b$ | $S_2 \times b_2 = 0.028$ |

(continued)

| Table 1: Calculation example of overall oxygen permeability when oxygen permeability of each portion changes and gas barrier properties | | | | | |
|---|---|---|---|---|---|
| | | CASE 1 | | CASE 2 | |
| Region 203 | $S_3 = 0.2S$ | $b_3 = 1/3\,b$ | $S_3 \times b_3 = 0.067$ | $b_3 = 1/6\,b$ | $S_3 \times b_3 = 0.033$ |
| | | Overall B | 0.151667 | Overall B | 0.091 |
| | | BIF | 6.6 | BIF | 11.0 |

It can be said that the gas barrier properties of the entire container 2 are improved by improving the gas barrier properties of the regions 201 and 202, which have a larger surface area and are poor in gas barrier properties as the total surface area reaches 1/2 of the surface area of the entire container 2b, even though the gas barrier properties of the region 202 with the best gas barrier properties are somewhat deteriorated, from CASE 1 and CASE 2.

[Use of Described Technology of Japanese Patent No. 5355860]

By the way, in the present disclosure, a means for making a voltage applied to the inner surface of the container 2 uniform can be used based on the description of Japanese Patent No. 5355860.

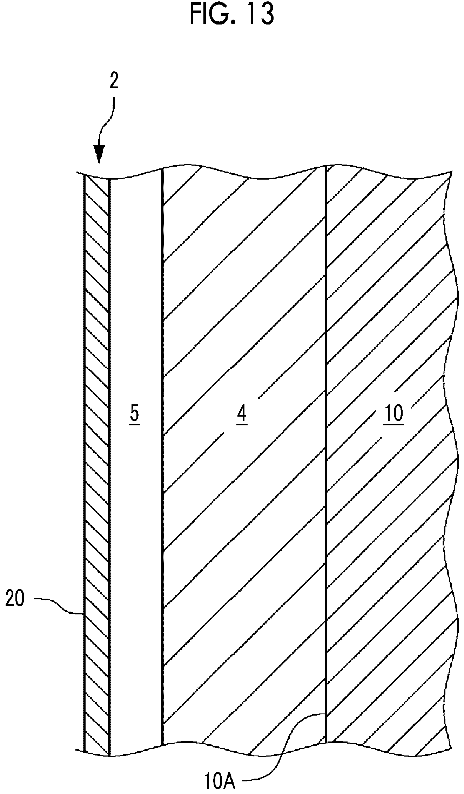

As schematically shown in Fig. 13, a dielectric member 4 and a gap 5 exist between the container 2 and the external electrode 10.

For example, at a point B (Fig. 10A) on a vertical section of the container 2, the dielectric member 4 corresponds to the first dielectric member 12 and the second dielectric portion 32 of the auxiliary tool 3. The dielectric member 4 corresponds to the first dielectric member 12 at a point C. In addition, at a point D in Fig. 11B, the dielectric member 4 corresponds to the second dielectric portion 32 of the auxiliary tool 3x.

The gap 5 corresponds to, for example, the gap between the auxiliary tool 3 and the neck portion 22 and the gap between the auxiliary tool 3 and the first dielectric member 12 at the point B (Fig. 10A). The gap 5 corresponds to a gap between the body portion 23 and the first dielectric member 12 at the point C. In addition, the gap 5 corresponds to the gap between the neck portion 22 and the auxiliary tool 3 at the point D in Fig. 11B.

In Japanese Patent No. 5355860, a voltage applied to the inner surface of the container 2 is made uniform using the dielectric member 4 and the gap 5. The gist thereof is to combine a material for the dielectric member 4, thicknesses of the dielectric member 4 and the gap 5, and a shape of the external electrode 10 such that a sum of conversion distances $(d_i/\varepsilon_i)$ obtained by dividing a thickness $(d_i)$ of the dielectric member 4 or the gap 5 by a dielectric constant $(\varepsilon_i)$ is uniform in the entire container 2 from an inner surface 10A of the external electrode 10 to an inner surface 20 of the container 2. In this manner, the following condition A) is satisfied.

Condition A)

A value obtained by dividing a standard deviation of a sum of the respective points in the entire container 2 by an average value is 0.75 or less, the sum being a sum of the conversion distances $(d_i/\varepsilon_i)$ obtained by dividing the thickness $(d_i)$ of the dielectric member 4 or the gap 5 at each surface point from the inner surface 10A of the external electrode 10 to the inner surface 20 of the container 2 on the vertical section of the container 2 by the dielectric constant $(\varepsilon_i)$.

Next, from the gist described above, Japanese Patent No. 5355860 presents the following condition B).

Condition B)

A ratio (Gmax/Gmin) of a maximum value Gmax to a minimum value Gmin of a conversion distance G, which is a sum of values obtained by dividing the thickness $(d_i)$ of the dielectric member 4 or the gap 5 by the dielectric constant $(\varepsilon_i)$, in a shortest distance from the inner surface 20 of the container 2 to the dielectric member 4 or the external electrode 10 in each part of the container 2 is 11 or less.

Further, from the above gist, Japanese Patent No. 5355860 presents the following condition C).

Condition C) An average thickness of the dielectric member 4/the dielectric constant is in a range of 0.95 to 3.8.

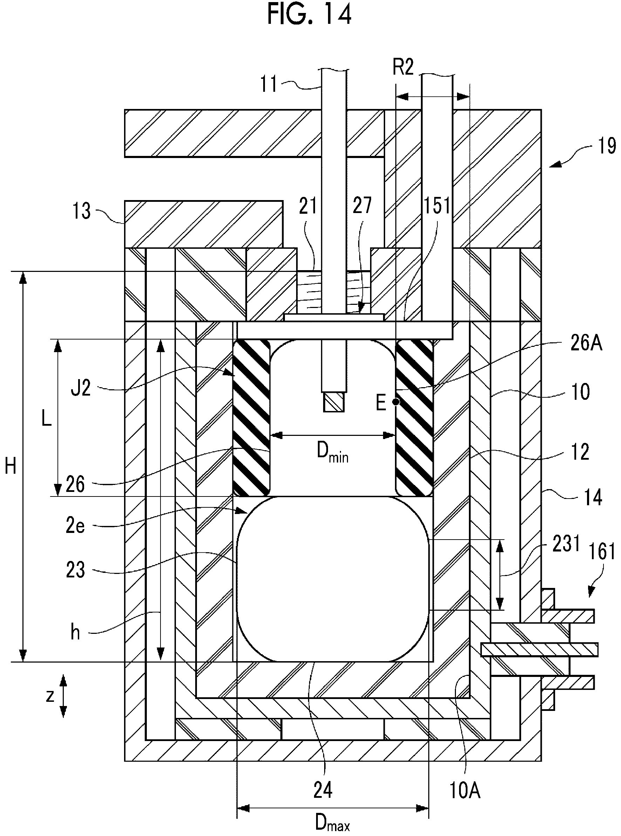

Next, results of calculation for a container 2e, an auxiliary tool J2 consisting of a dielectric, and the film-forming device 1 shown in Fig. 14 under the above conditions A to C are shown. The dielectric member 4 in Fig. 13 corresponds to the first dielectric member 12 and the auxiliary tool J2 at a point E in Fig. 14.

The container 2e has a small diameter portion 26 that has a smaller dimension in the radial direction than that of the body portion 23 and that is long in the height direction and a neck portion 27 that is gripped by the gripper 151, similar to the neck portion 22 of the container 2 of the present embodiment. The length L of the small diameter portion 26 in the height direction is substantially half of the effective film formation height h.

The small diameter portion 26 is positioned between the neck portion 27 and the body portion 23 and has a constant diameter Dmin. The diameter Dmin is smaller than a maximum diameter Dmax of the container 2e by 20 mm or more.

The auxiliary tool J2 consists of the dielectric portion as a whole. The auxiliary tool J2 has a cylindrical shape in both an inner peripheral portion and an outer peripheral portion and is disposed between the small diameter portion 26 and the first dielectric 12 over the length L.

When the value of the condition A) is calculated for the container 2e, the auxiliary tool J2, and the film-forming device 1, the value is 0.20, and thus the condition A) is satisfied. In addition, when Gmax/Gmin is calculated for the conversion distance G, and the result is 2.2. Therefore, the condition B) is satisfied. Further, as a result of calculation, the average thickness of the dielectric member 4/the dielectric constant is 5.8. This value does not satisfy the condition C).

The reason why the container 2e does not satisfy the condition C) is that, as described above, gas barrier properties are the sum of gas barrier properties of each part of the container. The container 2e has good gas barrier properties over a range 231 of a maximum outer diameter of the body portion 23, but the range 231 is only approximately 1/5 of the effective film formation height h of the container 2e. The remaining portion of the container 2e has lower gas barrier properties than those of the range 231.

In the remaining portion, the length L of the small diameter portion 26 having the lowest barrier properties since a diameter difference is the largest with respect to the range 231 occupies approximately half of the effective height h.

In addition, since the external electrode 10 is formed in a cylindrical shape over the entire up-down direction z, a distance from the cylindrical inner surface 10A to an outer surface 26A of the small diameter portion 26 is long. For this reason, the first dielectric member 12 and the auxiliary tool J2 are disposed as the thick dielectric member 4 between the small diameter portion 26 and the first dielectric member 12.

That is, since the container 2e has only approximately half of a region where sufficient gas barrier properties can be obtained at most, and the dielectric member 4 is excessively thick so that a dielectric loss is large, the gas barrier properties of the container 2e are insufficient.

In order to improve the gas barrier properties from the condition B) described above, the conversion distance G related to the dielectric member 4 (the first dielectric member 12 and the auxiliary tool J2) and the gap needs to be reduced in a range R2 from the inner surface 10A of the external electrode 10 to the outer surface 26A of the small diameter portion 26. In addition, when a difference between the maximum diameter and the minimum diameter in an effective film formation range is large as in the container 2e, it is difficult to satisfy the condition C.

Thus, by using the auxiliary tool 3 of the present disclosure instead of the auxiliary tool J2, the conductor portion 31 may be disposed in the range R2 from the inner surface 10A of the external electrode 10 to the outer surface 26A of the small diameter portion 26. However, in the range R2, only the dielectric member 4 (the first region 321 of the second dielectric portion 32) facing the container 2 needs to be left from the viewpoint of suppressing occurrence of abnormal discharge.

The conversion distance G is not taken into account with respect to the conductor portion 31. For this reason, as the thicknesses of the dielectric member 4 and the gap 5 disposed in the range R2 decrease by the thickness of the conductor portion 31, the conversion distance G decreases and the dielectric loss also decreases, so that the gas barrier properties of the container 2e can be sufficiently improved. The term "thickness" described herein corresponds to a dimension of the container 2 or the external electrode 10 in the radial direction.

Then, from the number theory of the conversion distance G described above, the gas barrier properties can be adjusted by adjusting a ratio of the thickness of the conductor portion 31 of the auxiliary tool 3 to the thickness of the second dielectric portion 32. Even when it is difficult to adjust the thickness of the external electrode 10 that also serves as a vacuum chamber or the first dielectric member 12 already provided in the external electrode 10, it is possible to easily produce the auxiliary tool 3 in which a ratio of a thickness $d_c$ of the conductor portion 31 to a thickness $d_d$ of the second dielectric portion 32 is different from that of the entire thickness $d_{all}$ (Fig. 4A).

[Effects of Present Embodiment]

As described above, with the auxiliary tool 3 for film formation of the present embodiment, the film-forming device 1 including the auxiliary tool 3, and a method for manufacturing the film-coated container 2c using the auxiliary tool 3, sufficient gas barrier properties even for the container 2 having a special shape to which it is difficult to impart sufficient gas barrier properties in the related art can be ensured while suppressing occurrence of abnormal discharge.

It is easy to prepare a plurality of types of auxiliary tools 3 having different shapes according to the shape of the container 2, dimensions of the inside of the chamber, and the like. In comparison thereto, it is not necessary to change the shape of the first dielectric member 12 or the external electrode 10, which causes a large cost and a large work burden when changing a mold.

According to the present embodiment, it is possible to realize the required level of gas barrier properties in the container 2 having various shapes by selecting the shape of the auxiliary tool 3, setting a ratio of the thickness of the conductor portion 31 to the thickness of the second dielectric portion 32, and the like.

[Modification Example]

Hereinafter, a modification example of the present disclosure will be described. The same reference signs are assigned to the same elements as the elements described above.

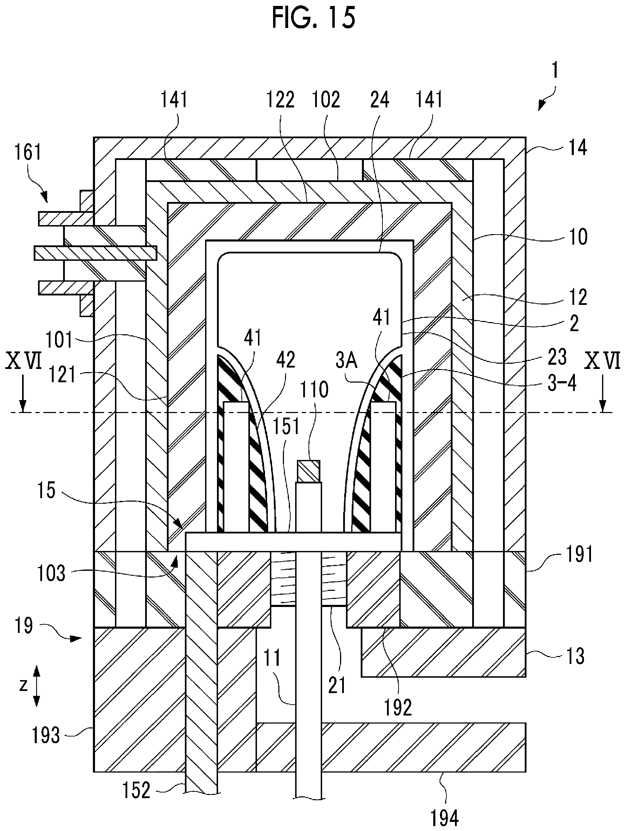

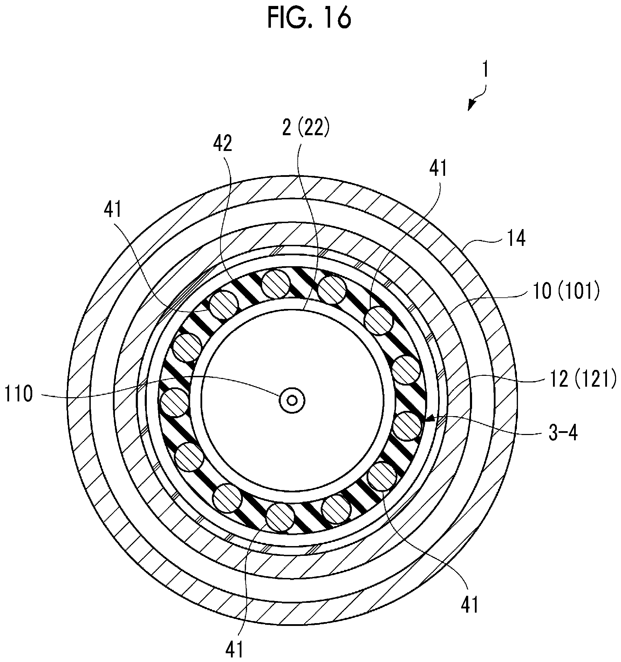

An auxiliary tool 3-4 shown in Figs. 15 and 16 includes a second dielectric portion 42 and a plurality of round bars 41 which are conductor portions filling the inside of the second dielectric portion 42. As shown in Fig. 16, the plurality of round bars 41 are arranged at equal intervals in a circumferential direction of the cylindrical second dielectric portion 42.

The round bars 41 are formed of, for example, aluminum or an alloy thereof. The second dielectric portion 42 is formed of, for example, PTFE. The round bars 41 are inserted into holes formed in the second dielectric portion 42 through hole processing.

Herein, the results of the film formation test performed by the film-forming device 1 in the present modification example, the embodiment described above, and the comparative example are shown in the following table. In the embodiment, the auxiliary tool 3 in which the second dielectric portion 32 is provided on the conductor portion 31 made of aluminum through coating of PTFE is used. In the comparative example, as in the example shown in Fig. 14, the auxiliary tool J2 consisting of only the dielectric is used in the film formation of the container 2, which is the same as in the modification example and the embodiment. The shape of the auxiliary tool J2 used at this time is the same as the shape of the auxiliary tool 3 or the auxiliary tool 3-4. A radio frequency (RF) output of the high-frequency power supply 17, a film forming time, and the flow rate of a raw material gas are as shown in table 2 below. Standard cubic centimeter per minute (sccm), which is a unit of the flow rate, refers to ccm (cc/min) converted into a value at 1 atm and 0°C.

[Table 2]

| Table 2: Results of film formation test | | Embodiment | Modification example | Comparative Example |
|---|---|---|---|---|
| Configuration of film formation jig | Dielectric member | PTFE coating | PTFE molded body | PTFE molded body |
| | Conductive member | Aluminum molded body | Aluminum round bar | - |
| RF output [W] | | 400 | 400 | 400 |
| Film forming time [sec] | | 1.5 | 1.6 | 1.6 |
| Gas flow rate [sccm] | | 60 | 60 | 60 |
| BIF [times] | | 6.1 | 3.1 | 2.6 |

From table 2, the gas barrier properties of the embodiment are more than twice the gas barrier properties of the comparative example and reach the required level. In addition, even in the modification example, the gas barrier properties can be improved compared to the comparative example.

From the above table, according to the embodiment in which a ratio of the thickness of the conductor portion 31 to the thickness of the entire auxiliary tool 3 is significantly high, sufficiently high gas barrier properties can be obtained. Depending on the shape of the container 2, the required level of gas barrier properties can be expected according to the modification example. In addition, improvement of the gas barrier properties is expected due to an increase in the volume of the conductor portion 41 in the auxiliary tool 3-4.

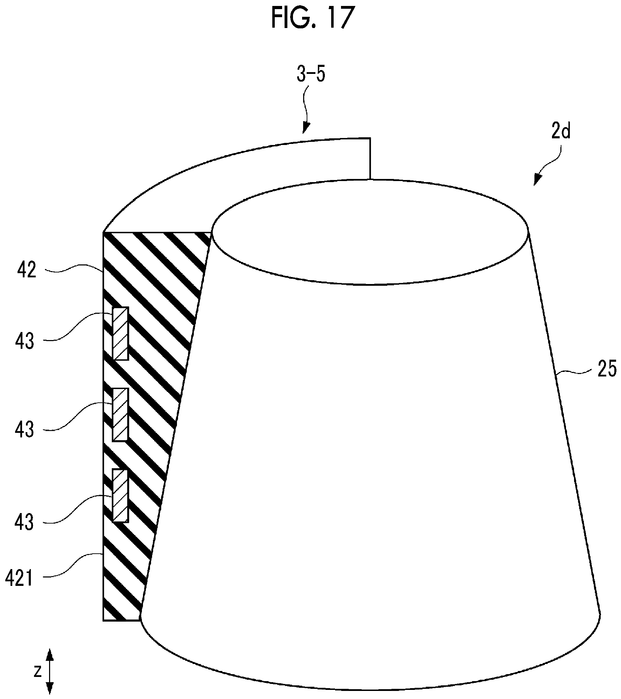

Fig. 17 is a schematic view showing a part of an auxiliary tool 3-5 that is disposed around a small diameter portion 25 of the container. The auxiliary tool 3-5 includes, for example, the second dielectric portion 42 made of PTFE and a plurality of strip-shaped conductor portions 43 that are inserted into grooves formed therein. The auxiliary tool 3-5 can be configured by being divided into a plurality of members. Each of the plurality of conductor portions 43 in a state of being arranged in the up-down direction z is continuous along a circumferential direction of the small diameter portion 25.

The plurality of strip-shaped conductor portions 43 may be exposed to an outer peripheral portion 421 of the second dielectric portion 42.

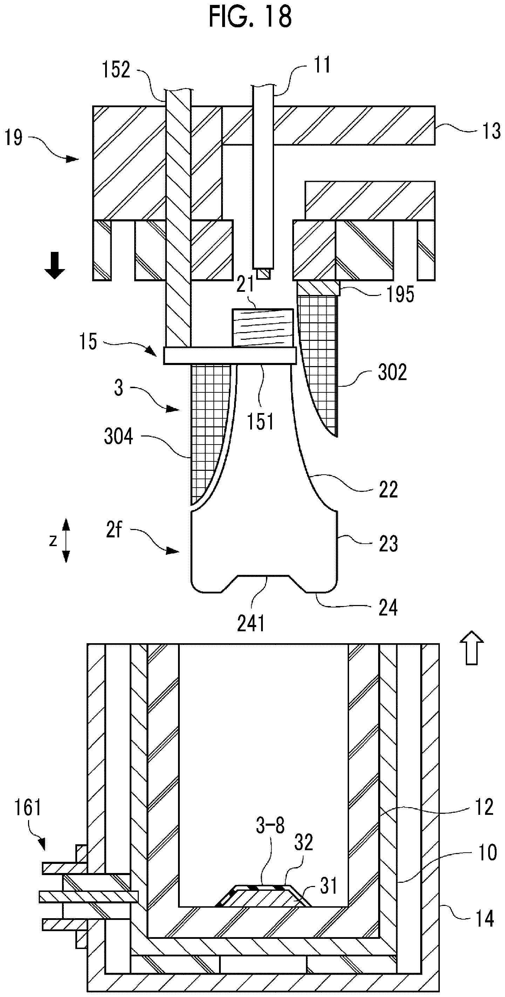

Fig. 18 shows an example in which an auxiliary tool 3-8 having a shape corresponding to a concave portion 241 formed in the bottom portion 24 is used in addition to the auxiliary tool 3 having a shape corresponding to the neck portion 22 of a container 2f. The auxiliary tool 3-8 includes the truncated cone-shaped conductor portion 31 that follows the shape of the concave portion 241 and the second dielectric portion 32 that is a coating film covering the surface of the conductor portion 31.

The auxiliary tool 3-8 can be provided, for example, at the bottom portion of the first dielectric 12. Since the film quality, the film thickness, and the like of a barrier film formed in the concave portion 241 are improved by the auxiliary tool 3-8, the gas barrier properties of the entire container 2f can be improved. It is possible to adjust the gas barrier properties by adjusting the thickness (dimension in the up-down direction z) of each of the conductor portion 31 and the second dielectric portion 32.

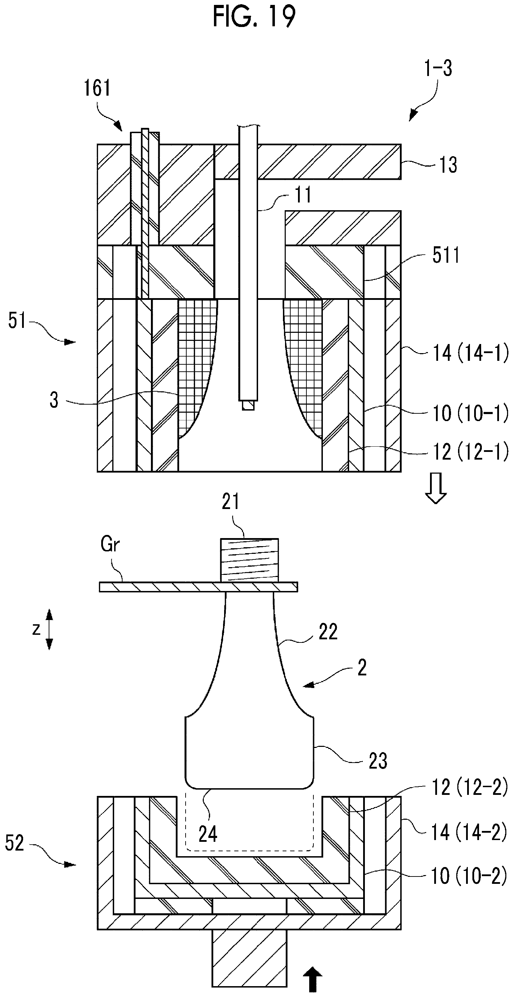

The container 2 shown in Fig. 19 is supported by a first dielectric member 12-2 of a lower assembly 52 while the container 2 is disposed in the chamber and the film formation treatment is being performed. For this reason, a film-forming device 1-3 does not include the grip tool 15 that grips the neck portion 22 of the container 2. The auxiliary tool 3 is supported by a first dielectric member 12-1 or an insulating member 511 of an upper assembly 51.

The external electrode 10, the first dielectric member 12, and the shield member 14 of the film-forming device 1-3 are each divided into an upper side and a lower side, and a division surface is opened and closed by the elevating mechanism (not shown).

As shown in the drawing, the grip tool Gr is opened in a state where the chamber is open, and the container 2 is received on the lower first dielectric member 12-2 in the upright posture. Next, when the grip tool Gr is retracted from the container 2 and the upper assembly 51 is lowered toward the container 2, a chamber space is formed between an upper external electrode 10-1 and the lower external electrode 10-2, and the auxiliary tool 3 is disposed around the neck portion 22.

In addition to the above, it is possible to select the configurations described in the embodiment described above or to change the configurations to other configurations as appropriate.

The film forming auxiliary tool of the present disclosure can be given an appropriate shape according to various shapes of various containers 2. A region of the container 2 where the auxiliary tool 3 is disposed is not limited to the neck portion 22 or the vicinity thereof and may be, for example, a concave portion formed in the body portion 23.

[Supplementary Notes]

From the above disclosure, the following configurations are understood.

[1] A film forming auxiliary tool (3) that is used in a film-forming device (1) performing film formation on an inner surface of a container (2) is configured to be inserted into an external electrode (10) that accommodates the container (2). The auxiliary tool (3) includes a conductor portion (31) and a dielectric portion (32) that is stacked on the conductor portion (31). When the auxiliary tool (3) is inserted into the external electrode (10), the dielectric portion (32) faces an outer surface of the container (2), and when the auxiliary tool (3) is inserted into the external electrode (10), the dielectric portion (32) and the conductor portion (31) are disposed in this order from a container (2) side between the container (2) and the external electrode (10).

[2] The film forming auxiliary tool (3) according to [1], in which a thickness of the conductor portion (31) in a radial direction of the container (2) is larger than a thickness of the dielectric portion (32) in the radial direction.

[3] The film forming auxiliary tool (3) according to [1] or [2], in which the conductor portion (31) is disposed inside the dielectric portion (32) or is disposed on an external electrode (10) side of a region (321) of the dielectric portion (32) on the container (2) side.

[4] The film forming auxiliary tool (3) according to any one of [1] to [3], in which the dielectric portion (32) corresponds to a coating film (32) that covers at least a surface of the conductor portion (31) on the container (2) side.

[5] The film forming auxiliary tool (3) according to any one of [1] to [4], in which the auxiliary tool (3) is divided into a plurality of segments (301 to 304) in a circumferential direction of the container (2).

[6] The film forming auxiliary tool (3) according to any one of [1] to [5], in which the auxiliary tool (3) is disposed around a small diameter portion (22, 25, 26) that has a smaller dimension in a radial direction of the container (2) formed in a bottle shape than a body portion (23) that has a largest dimension in the radial direction.

[7] The film forming auxiliary tool (3) according to [6], in which the auxiliary tool (3) is configured to be attached to a grip tool (15) that grips a predetermined location in a neck portion (22) of the container (2).

[8] The film forming auxiliary tool (3) according to [6] or [7], in which the small diameter portion (22, 26) extends in a height direction over 1/3 or more of a height of the container (2).

[9] A film-forming device (1) that is a device (1) performing film formation on an inner surface of a container (2) and that includes an external electrode (10) that is configured to accommodate the container (2), an internal electrode (11) that is disposed inside the container (2), and the auxiliary tool (3) according to any one of [1] to [8].

[10] The film-forming device (1) according to [9] is the film-forming device (1) including an existing dielectric portion (12) that is provided in advance inside the external electrode (10), in which when the auxiliary tool (3) is inserted into the existing dielectric portion (12), the dielectric portion (32) of the auxiliary tool (3) faces a region of a part of the outer surface of the container (2), and the existing dielectric portion (12) faces other regions of the outer surface of the container (2).

[11] The film-forming device (1) according to [9] or [10], in which the auxiliary tool (3) is divided into a plurality of segments (301 to 304) in a circumferential direction of the container (2), a separated segment (302) that is at least one of the segments of the auxiliary tool (3) is attached to a support (19) that supports the internal electrode (11), the segments (301, 303, 304) excluding the separated segment (302) of the auxiliary tool (3) are attached to a grip tool (15) that grips a predetermined location in a neck portion (22) of the container (2), and when the container (2) is accommodated in the external electrode (10) and the internal electrode (11) is inserted into the container (22), all the segments (301 to 304) of the auxiliary tool (3) are disposed around the container (2).

[12] The film-forming device (1) according to any one of [9] to [11] is the film-forming device (1) including an alternating electric field source (17) that applies an alternating electric field between the external electrode (10) and the internal electrode, a shield member (14) that surrounds the external electrode (10) in a state of being insulated from the external electrode (10) and that is grounded, an exhaust unit (13) that exhausts a space where the container (2) is disposed, and a gas introduction portion (11) that introduces a gas containing a raw material for a film to be applied to the container (2) into the container (2).

[13] The film-forming device (1) according to any one of [9] to [12] is the film-forming device (1) including a grip tool (15) that grips a predetermined location in a neck portion (22) of the container (2) formed in a bottle shape, in which the grip tool (15) corresponds to a dielectric.

[14] A method for manufacturing a film-coated container (2c), which is a method for manufacturing a container (2) having a coating film on an inner surface of the container (2), the method including a step (S03) of disposing the auxiliary tool (3) according to any one of [1] to [8] around the container (2), a step (S02, S03) of accommodating the container (2) and the auxiliary tool (3) inside the external electrode (10), a step (S04) of exhausting a space where the container (2) is disposed and introducing a gas containing a raw material for a film to be applied to the container (2), and a step (S05) of applying an electric field between the external electrode (10) and an internal electrode (11) disposed inside the container (2).

Reference Signs List

1, 1-2, 1-3: film-forming device
2, 2r, 2b: container
2r1, 2r2, 2r3, 2r4: side surface
2c: film-coated container
3, 3r: auxiliary tool (film forming auxiliary tool)
3A: facing surface
3B: back surface
4: dielectric member
5: gap
10: external electrode
10A: inner surface
10x: external electrode
11: internal electrode (internal electrode, gas introduction portion)
12: first dielectric member (existing dielectric member)
13: exhaust unit
13A: flow path
14: shield member
15: grip tool
17: high-frequency power supply
18: vacuum suction device
19: assembly (support)
20: inner surface
21: mouth portion
22: neck portion (small diameter portion)
23: body portion
24: bottom portion
26: small diameter portion
27: neck portion
28: shoulder

26A: outer surface

31: conductor portion

31B: back surface

31C: bottom surface

32: second dielectric portion (coating film)

41: round bar (conductor portion)

42: second dielectric portion

51: upper assembly

52: lower assembly

101: peripheral wall

102: upper wall

103: opening

110: dielectric

121: peripheral wall

122: upper wall

141: insulating member

151: gripper

152: support member

161: connector

162: matching device

191 to 195: insulating member

301 to 304: segment (including separated segment 302)

321: first region

322: second region

323: third region

A: axis

Gr: grip tool

H: height

h: effective film formation height

J1, J2: auxiliary tool

L: length

R1: projection region

R2: range

S01: container supply step

S02: container accommodating step

S03: internal electrode inserting and auxiliary tool disposing step

S04: exhausting and raw material gas introducing step

S05: electric field applying step

S06: atmospheric opening step

S07: container discharge step

z: up-down direction

## Claims

1. A film forming auxiliary tool that is used in a film-forming device performing film formation on an inner surface of a container,
   in which the auxiliary tool is configured to be inserted into an external electrode that accommodates the container, the auxiliary tool comprising:

   a conductor portion; and
   a dielectric portion that is stacked on the conductor portion,
   wherein when the auxiliary tool is inserted into the external electrode, the dielectric portion faces an outer surface of the container, and
   when the auxiliary tool is inserted into the external electrode, the dielectric portion and the conductor portion are disposed in this order from a container side between the container and the external electrode.

2. The film forming auxiliary tool according to claim 1,

wherein a thickness of the conductor portion in a radial direction of the container is larger than a thickness of the dielectric portion in the radial direction.

3. The film forming auxiliary tool according to claim 1 or 2,
   wherein the conductor portion is disposed inside the dielectric portion or is disposed on an external electrode side of a region of the dielectric portion on the container side.

4. The film forming auxiliary tool according to claim 1 or 2,
   wherein the dielectric portion corresponds to a coating film that covers at least a surface of the conductor portion on the container side.

5. The film forming auxiliary tool according to claim 1 or 2,
   wherein the auxiliary tool is divided into a plurality of segments in a circumferential direction of the container.

6. The film forming auxiliary tool according to claim 1 or 2,
   wherein the auxiliary tool is disposed around a small diameter portion that has a smaller dimension in a radial direction of the container formed in a bottle shape than a body portion that has a largest dimension in the radial direction.

7. The film forming auxiliary tool according to claim 6,
   wherein the auxiliary tool is configured to be attached to a grip tool that grips a predetermined location in a neck portion of the container.

8. The film forming auxiliary tool according to claim 6,
   wherein the small diameter portion extends in a height direction over 1/3 or more of a height of the container.

9. A film-forming device that is a device performing film formation on an inner surface of a container, the film-forming device comprising:

   an external electrode that is configured to accommodate the container;
   an internal electrode that is disposed inside the container; and
   the auxiliary tool according to claim 1 or 2.

10. The film-forming device according to claim 9, further comprising:

    an existing dielectric portion that is provided in advance inside the external electrode,
    wherein when the auxiliary tool is inserted into the existing dielectric portion, the dielectric portion of the auxiliary tool faces a region of a part of the outer surface of the container, and
    the existing dielectric portion faces other regions of the outer surface of the container.

11. The film-forming device according to claim 9,

    wherein the auxiliary tool is divided into a plurality of segments in a circumferential direction of the container,
    a separated segment that is at least one of the segments of the auxiliary tool is attached to a support that supports the internal electrode,
    the segments excluding the separated segment of the auxiliary tool are attached to a grip tool that grips a predetermined location in a neck portion of the container, and
    when the container is accommodated in the external electrode and the internal electrode is inserted into the container, all the segments of the auxiliary tool are disposed around the container.

12. The film-forming device according to claim 9, further comprising:

    an alternating electric field source that applies an alternating electric field between the external electrode and the internal electrode;
    a shield member that surrounds the external electrode in a state of being insulated from the external electrode and that is grounded;
    an exhaust unit that exhausts a space where the container is disposed; and
    a gas introduction portion that introduces a gas containing a raw material for a film to be applied to the container into the container.

**13.** The film-forming device according to claim 9, further comprising:

a grip tool that grips a predetermined location in a neck portion of the container formed in a bottle shape, wherein the grip tool corresponds to a dielectric.

**14.** A method for manufacturing a film-coated container, which is a method for manufacturing a container having a coating film on an inner surface of the container, the method comprising:

a step of disposing the auxiliary tool according to claim 1 or 2 around the container;
a step of accommodating the container and the auxiliary tool inside the external electrode;
a step of exhausting a space where the container is disposed and introducing a gas containing a raw material for a film to be applied to the container; and
a step of applying an electric field between the external electrode and an internal electrode disposed inside the container.

# FIG. 1

# FIG. 2A

# FIG. 2B

FIG. 3

FIG. 4A

FIG. 4B

FIG. 4C

FIG. 4D

# FIG. 5

```
        ┌─────────────┐
        │    START    │
        └──────┬──────┘
               ▼
   ┌───────────────────────┐
   │  SUPPLY OF CONTAINER  │────  S01
   └───────────┬───────────┘
               ▼
   ┌───────────────────────┐
   │     ACCOMMODATE       │────  S02
   │ CONTAINER IN CHAMBER  │
   └───────────┬───────────┘
               ▼
   ┌───────────────────────┐
   │   INSERT INTERNAL     │
   │ ELECTRODE IN CONTAINER│
   │  DISPOSE FILM FORMING │────  S03
   │ AUXILIARY TOOL OVER   │
   │  ENTIRE PERIPHERY OF  │
   │      CONTAINER        │
   └───────────┬───────────┘
               ▼
   ┌───────────────────────┐
   │ EXHAUST AND INTRODUCE │────  S04
   │   RAW MATERIAL GAS    │
   └───────────┬───────────┘
               ▼
   ┌───────────────────────┐
   │  APPLY HIGH-FREQUENCY │────  S05
   │    ELECTRIC FIELD     │
   └───────────┬───────────┘
               ▼
   ┌───────────────────────┐
   │    INTRODUCE AIR      │────  S06
   │ (ATMOSPHERIC OPENING) │
   └───────────┬───────────┘
               ▼
   ┌───────────────────────┐
   │ DISCHARGE OF CONTAINER│────  S07
   └───────────┬───────────┘
               ▼
        ┌─────────────┐
        │     END     │
        └─────────────┘
```

# FIG. 6

# FIG. 7

# FIG. 8A

# FIG. 8B

# FIG. 9

## FIG. 10A

## FIG. 10B

## FIG. 11A

## FIG. 11B

# FIG. 12

2b

201

202

203

# FIG. 13

# FIG. 14

# FIG. 15

# FIG. 16

# FIG. 17

# FIG. 18

## FIG. 19

## INTERNATIONAL SEARCH REPORT

| International application No. |
| --- |
| **PCT/JP2023/018681** |

### A. CLASSIFICATION OF SUBJECT MATTER

*B65D 23/02*(2006.01)i; *C23C 16/505*(2006.01)i
FI:    C23C16/505; B65D23/02 Z

According to International Patent Classification (IPC) or to both national classification and IPC

### B. FIELDS SEARCHED

Minimum documentation searched (classification system followed by classification symbols)

B65D23/02; C23C16/505

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| A | JP 2008-50678 A (MITSUBISHI SHOJI PLAST. KK) 06 March 2008 (2008-03-06) entire text, all drawings | 1-14 |
| A | JP 2008-88472 A (MITSUBISHI SHOJI PLAST. KK) 17 April 2008 (2008-04-17) entire text, all drawings | 1-14 |
| A | JP 2016-156083 A (YOSHINO KOGYOSHO CO., LTD.) 01 September 2016 (2016-09-01) entire text, all drawings | 1-14 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **25 July 2023** | **08 August 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

INTERNATIONAL SEARCH REPORT
Information on patent family members

International application No.

**PCT/JP2023/018681**

| Patent document cited in search report | | | Publication date (day/month/year) | Patent family member(s) | Publication date (day/month/year) |
|---|---|---|---|---|---|
| JP | 2008-50678 | A | 06 March 2008 | (Family: none) | |
| JP | 2008-88472 | A | 17 April 2008 | (Family: none) | |
| JP | 2016-156083 | A | 01 September 2016 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5355860 B
- JP 2019065318 A
- JP 2013256708 A
- JP 2009046182 A